(19) Europäisches Patentamt
European Patent Office
Office européen des brevets

(11) EP 2 883 881 A1

# (12) EUROPEAN PATENT APPLICATION

(43) Date of publication:
**17.06.2015 Bulletin 2015/25**

(21) Application number: **14003875.3**

(22) Date of filing: **18.11.2014**

(51) Int Cl.:
***C07F 15/06*** *(2006.01)* ***H01L 51/00*** *(2006.01)*
***H01L 31/0224*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.12.2013 EP 13005782**

(71) Applicant: **Merck Patent GmbH**
**64293 Darmstadt (DE)**

(72) Inventors:
- **Yoshizaki, Hiroki**
  **Tokyo 181-0002 (JP)**
- **Kawata, Kentaro**
  **Kanagawa, 243-0406 (JP)**
- **Goto, Tomohisa**
  **Sagamiharashi, Kanagawa, 252-0132 (JP)**

## (54) Cobaltcomplex salts and mixtures of Cobaltcomplex salts for use in DSSC

(57) The present invention relates to hybridized Cobaltcomplex salts having bis(fluorosulfonyl)imide anions or corresponding mixtures of unsubstituted and substituted Cobaltcomplex salts in electrolyte solutions and their use in electrochemical and/or optoelectronic devices. The present invention relates additionally to electrochemical and/or optoelectronic devices comprising said salts or electrolyte formulations comprising said salts. The present invention relates additionally to a method to enhance the solubility of Cobaltcomplex salts.



Printed by Jouve, 75001 PARIS (FR)

**Description**

Field of the Invention

The present invention relates to hybridized Cobaltcomplex salts having bis(fluorosulfonyl)imide anions according to formula (I) as described below, or to corresponding mixtures of unsubstituted and substituted Cobaltcomplex salts in electrolyte formulations and their use in electrochemical and/or optoelectronic devices. The present invention relates additionally to electrochemical and/or optoelectronic devices and electrolyte formulations comprising said salts. The present invention relates additionally to a method to enhance the solubility of Cobaltcomplex salts.

Background of the Invention

Dye-sensitized solar cells (DSSCs) are considered to be a promising alternative to cost-intensive silicon based photovoltaic devices. The working principle of a dye-sensitized solar cell is similar to that which Nature use in the leaves of the plants to convert carbon dioxide and water into carbohydrates and oxygen under sunlight. Chlorophyll in the leaves sensitize this process in the Nature. The first artificial sensitized solar cell was fabricated by covering titanium dioxide crystals with a layer of Chlorophyll.

Modern dye-sensitized solar cells are multicomponent systems which consist of semiconductor anode (an oxide, typically $TiO_2$, anatase), dye-sensitizer, counter-electrode (cathode) and electrolyte which contains a redox active species, solvent and some additives. The photoanode is constituted by a monolayer of a molecular redox dye sensitizer adsorbed onto a layer of nanocrystalline semiconductor nanoparticles. After light absorption, an excited state of the photosensitizer readily inject an electron into the conduction band of the semiconductor. The electron back transfer from the conduction band to dye cations is named interfacial charge recombination. This interfacial charge recombination competes kinetically with the reaction of the redox active species with the oxidized sensitizer. The redox active species becomes oxidized and the sensitizer becomes reduced and ready to be able to absorb light again. The reduction of the redox active species takes place in the charge transport layer, e.g. by the electrolyte formulation. The redox active species is often called mediator or redox shuttle and build a so-called redox couple. Charge transport by the electrolyte in the pores of the semiconductor film to the counter electrode and that of injected electrons within the nanocrystalline film to the back contact should be fast enough to compete efficiently with the electron recapture reaction [H. Nusbaumer et al, J. Phys. Chem. B2001, 105, 10461-10464]. In spite of DSSCs already achieved solar-to-electric power-conversion efficiency (PCE, $\eta$) of more than 11% (under standard air mass 1.5 and solar light intensity 1000 $W/m^2$ at 298 K), they are still a factor of 2 below that of Si-solar cells [J.-H. Yum, E. Baranoff, F. Kessler, T. Moehl, S. Ahmad, T. Bessho, A. Marchioro, E. Ghadiri, J.-E. Moser, C. Yi, Md. K. Nazeeruddin and M. Grätzel, Nature Communications, 3 (2012), p. 631]. For further improvement of the PCE the optimization of all components of DSSC and in particular of redox mediators are required. Electrolytes containing the $I^-/I_3^-$ redox system are commonly used in DSSC as the redox active species or mediator. However the $I^-/I_3^-$ redox couple suffers from a low redox potential which limits the open-circuit potential to 0.7-0.8 V of this type of DSSC. [H.N. Tsao, C. Yi, T. Moehl, J.-H. Yum, S.M. Zakeeruddin, M.K. Nazeeruddin and M. Grätzel, ChemSusChem, 4 (2011), p. 591 - 594.] Iodide-containing electrolytes also corrode current collectors in DSSC made from Ag or Cu. Therefore, the development of non-corrosive electrolytes with redox active species which better correspond to the oxidation potential of the dye is required.

Recently, several publications devoted to the use of cobalt redox shuttles, e.g. cobalt (III/II) tris(2,2'-bipyridine), in electrolyte formulations for DSSC or within the charge-transfer layer of solid state DSSC (sDSSC).

It is known that the oxidation of Co(II)-complexes and the reduction of Co(III)-complexes depend on the counter-anion and on the nature of the ligands coordinated on the metal centre.

Attempts have been made to improve the photovoltaic properties by substituting the bipyridyl ligand in 4 and 4' position with methyl groups or tert.-butyl groups (e.g. WO 2012001033 or J. Am. Chem. Soc. 2010, 132, 16714-16724).

There are especially two problems which hamper the use of Cobaltcomplex salts in DSSC electrolytes. The first problem is the limited solubility of the Cobaltcomplex salt in a desired solvent to form the electrolyte formulation. The second problem is the thermal stability of Cobaltcomplex-based DSSC electrolyte formulations.

As a result, there is a continuing demand for new and/or improved redox shuttles for electrochemical and optoelectronic devices.

The objective of the invention is therefore to provide an alternative and/or improved electrolytic formulation for electrochemical and optoelectronic devices.

Present Invention

Surprisingly, it was found that substitution with straight-chain or branched alkoxy groups having 1 to 4 C atoms at 3/3' position or 3/6' position of one or more of bipyridyl ligands within a Cobaltcomplex improves the solubility of the

Cobalt(II)complex salt. This effect is observed preferably with Cobaltcomplex salts having bis(fluorosulfonyl)imide, hexafluorophosphate or perchlorate anions.

Surprisingly it was further found that the replacement of at least one unsubstituted bipyridyl ligand with alkoxy substituted bipyridyl ligands in a Cobaltcomplex bis(fluorosulfonyl)imide improves the thermal stability of an electrochemical or an optoelectronic device comprising said salt. The initial power conversion efficiencies are the same or improved compared to the unsubstituted $Co(bipy)_3$-salt.

The present invention therefore relates to a method to enhance the solubility of Cobaltcomplex salts with bis(fluorosulfonyl)imide, hexafluorophosphate or perchlorate anions having bipyridyl ligands comprising the step of substituting the 3 and 3' position or the 3 and 6' position of the bipyridyl ligand with an alkoxy group having 1 to 4 C atoms.

Preferably, the solubility within the solvents acetonitril, gamma-butyrolactone and/or 3-methoxypropionitrile is enhanced.

In a preferred embodiment of the invention, the solubility of Cobaltcomplex salts with bis(fluorosulfonyl)imide, hexafluorophosphate or perchlorate anions having bipyridyl ligands within the solvents acetonitril, gamma-butyrolactone and 3-methoxypropionitrile is enhanced by substituting the 3 and 3' position of the bipyridyl ligand with an alkoxy group having 1 to 4 C atoms.

In another preferred embodiment of the invention, the solubility of Cobaltcomplex salts with bis(fluorosulfonyl)imide, hexafluorophosphate or perchlorate anions having bipyridyl ligands within the solvents acetonitril, gamma-butyrolactone and 3-methoxypropionitrile is enhanced by substituting the 3 and 6' position of the bipyridyl ligand with an alkoxy group having 1 to 4 C atoms.

A straight-chain or branched alkoxy group having 1 to 4 C atoms is e.g. methoxy, ethoxy, propoxy, isopropoxy, *n*-butoxy, *sec.*-butyoxy and *tert.*-butoxy. Preferably, the alkoxy group is a straight-chain alkoxy group selected from methoxy, ethoxy, propoxy and n-butoxy. Particularly preferably, the alkoxy group is methoxy.

The present invention furthermore relates to compounds of formula (I)

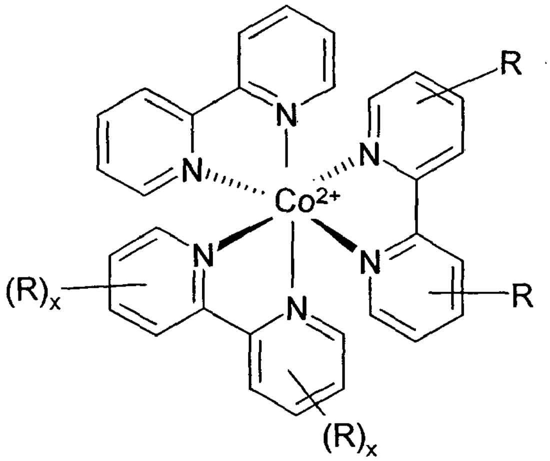

$2\ [N(FSO_2)_2]^-$ (I)

,

in which

x is 0 or 1 and

R is a straight-chain or branched alkoxy group with 1 to 4 C atoms.

Compounds of formula (I) are defined in such a way that the given formula comprises all possible stereoisomeric forms.

Compounds of formula (I) are also named "hybridized Cobaltcomplex salts" according to the invention because the ligand system is partially substituted by R as defined before.

R is preferably selected from methoxy, ethoxy, propoxy or n-butoxy. R is particularly preferably methoxy.

In one preferred embodiment of the invention, the position of the substituents "R" is in position 3 and 3' of the bipyridyl ligand thus forming compounds of formula (I-1)

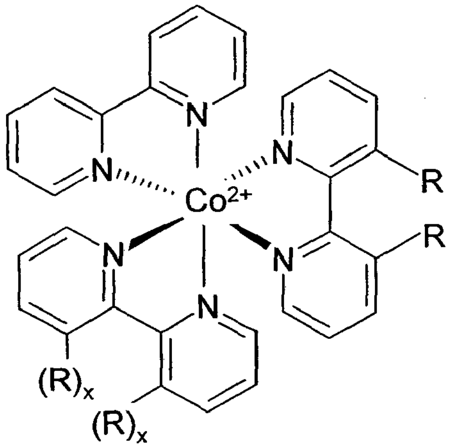

$2\ [N(FSO_2)_2]^-$ (I-1)

,

in which x and R are defined as described before or preferably described. Within this embodiment, x is preferably 1.

In one preferred embodiment of the invention, the position of the substituents "R" is in position 3 and 6' of the bipyridyl ligand thus forming compounds of formula (I-2)

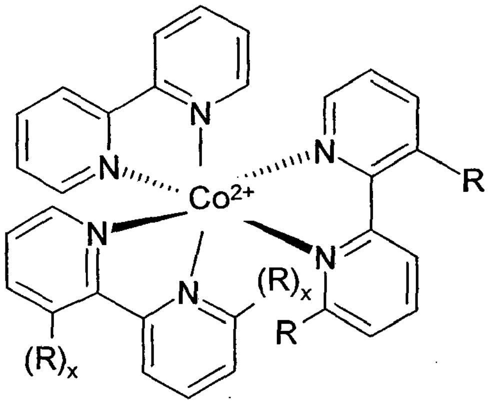

$2\ [N(FSO_2)_2]^-$ (I-2)

in which x and R are defined as described before or preferably described. Within this embodiment, x is preferably 0.

Compounds of formula (I-1) and (I-2) are defined in such a way that the given formula comprises all possible stereoisomeric forms.

Preferred examples of compounds of formula (I), (I-1) or (I-2) are the following compounds:

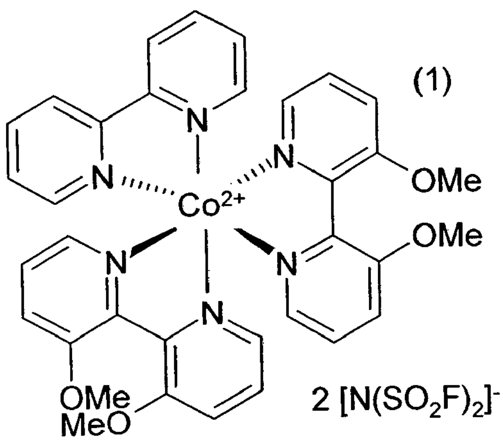

(1)

$2\ [N(SO_2F)_2]^-$ ,

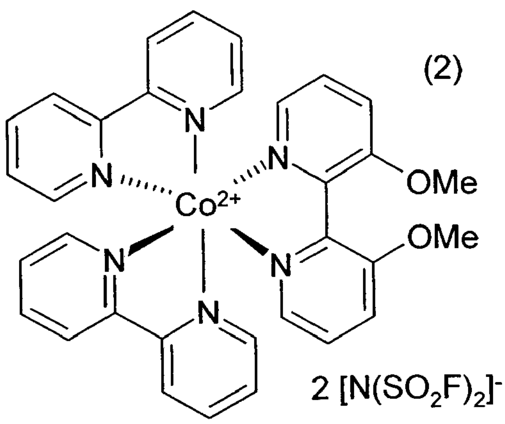

(2)

$2\ [N(SO_2F)_2]^-$ ,

(3)

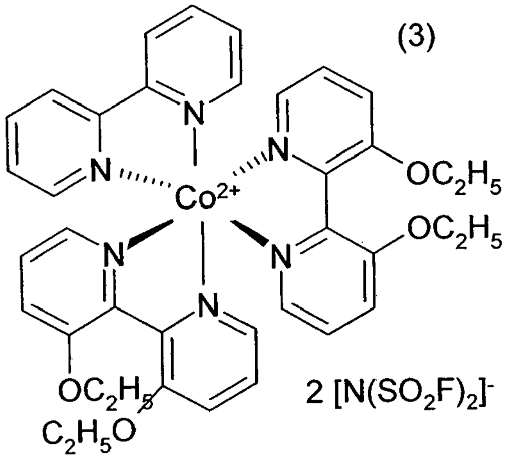

,

(4)

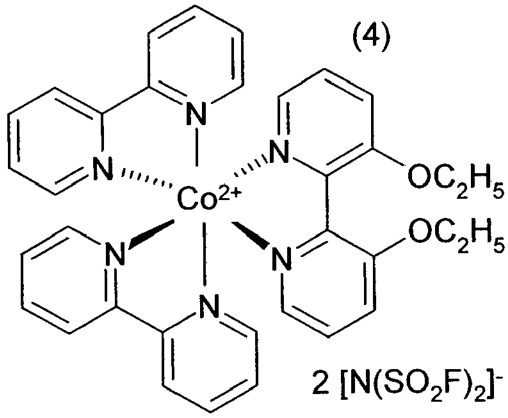

,

(5)

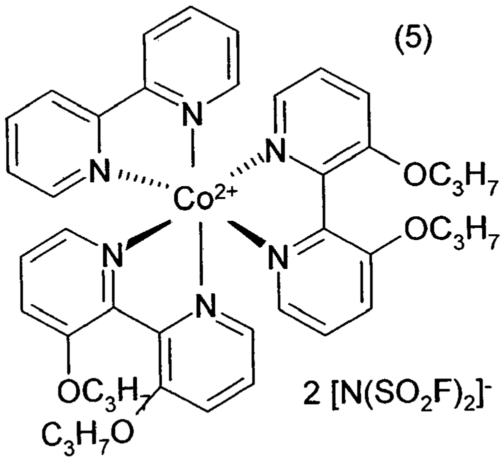

,

(6)

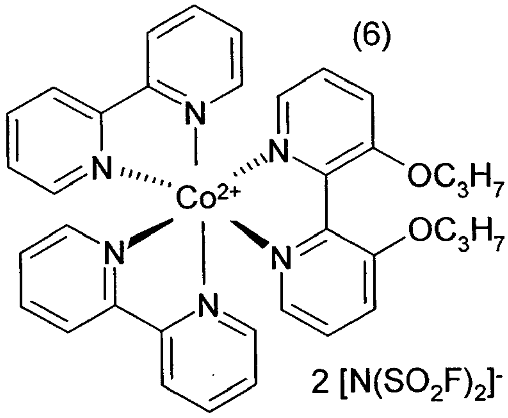

,

(7)

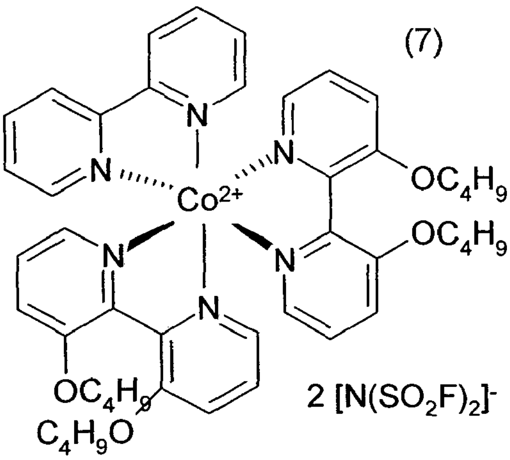

,

(8)

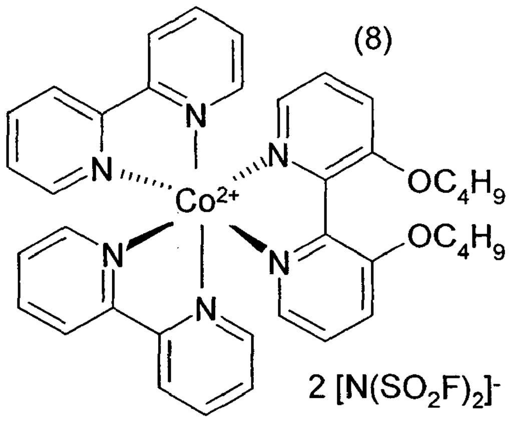

,

(9)

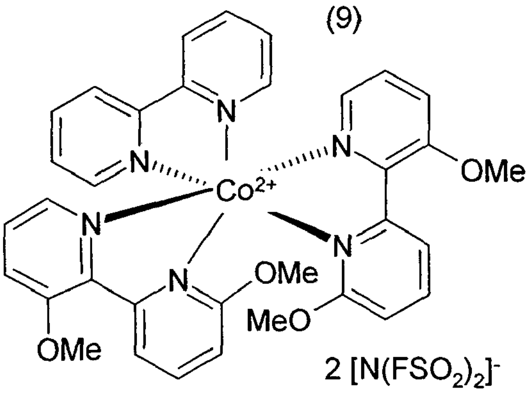

2 $[N(FSO_2)_2]^-$ ,

(10)

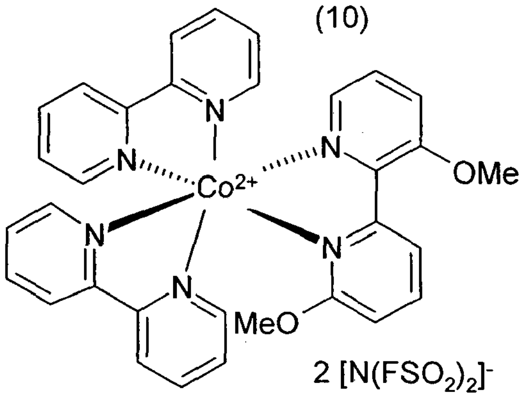

2 $[N(FSO_2)_2]^-$ .

OMe means methoxy.

Preferred compounds according to the invention are compound (1) and compound (10). A particularly preferred compound according to the invention is compound (1).

The compounds of formula (I), (I-1), (I-2), (1) to (10), as described before, can be used together with an oxidizer to form a redox shuttle to be used in a photovoltaic cell. Any oxidizer can be used which have a stronger oxidation power than the compound of formula (I), (I-1), (I-2), (1) to (10), as described before, and which reduced state is inert to the device performance.

In one embodiment of the invention, the compounds of formula (I), (I-1), (I-2), (1) to (10) can build a redox shuttle with nitrosyl compounds such as $NOBF_4$, $NOClO_4$, $NOSO_4H$, $(NO)_2XeF_8$ or $NOSnCl_6$. Such nitrosyl compounds are commercially available. A preferred nitrosyl compound is $NOBF_4$. This embodiment is preferred.

In another embodiment of the invention, the compounds of formula (I), (I-1), (I-2), (1) to (10) can be used as $Co^{II}/Co^{III}$-redox couples together with their corresponding Cobaltcomplex salt in which Co is in the oxidation state 3.

For example, a $Co^{II}/Co^{III}$-redox couple to the compound of formula (1) consists of the compounds (1) and ($1^+$):

(1)

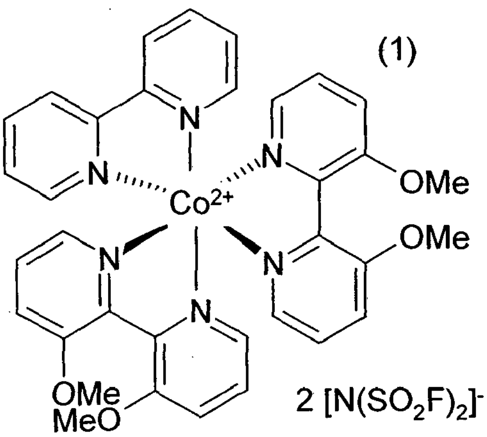

2 $[N(SO_2F)_2]^-$

($1^+$)

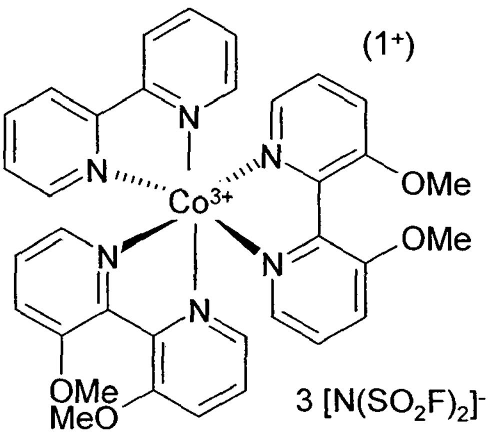

3 $[N(SO_2F)_2]^-$

$Co^{II}/Co^{III}$-redox couples to the compounds of formula (I), (I-1), (I-2), (1) to (10) are therefore the compounds of formula (I), (I-1), (I-2), (1) to (10) together with compounds of formula ($I^+$), ($I\text{-}1^+$), ($I\text{-}2^+$), ($1^+$) to ($10^+$), wherein R and x is defined as described before or preferably described:

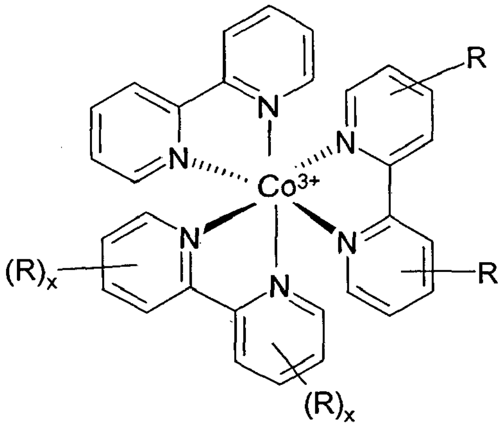

$3\,[N(FSO_2)_2]^-$ (I+)

,

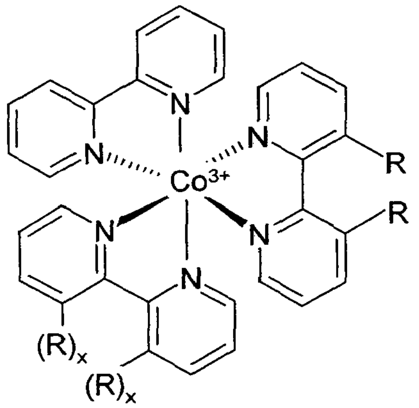

$3\,[N(FSO_2)_2]^-$ (I-1+)

,

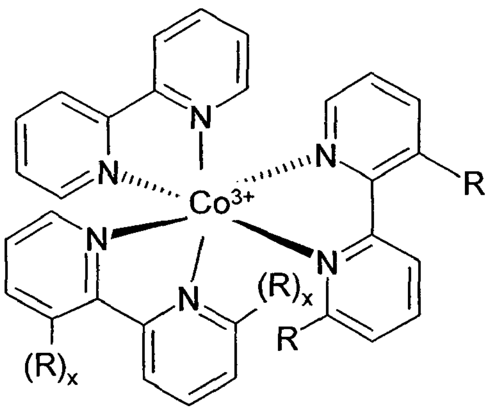

$3\,[N(FSO_2)_2]^-$ (I-2+)

,

wherein R and x is defined as described before or preferably described,

$(2^+)$

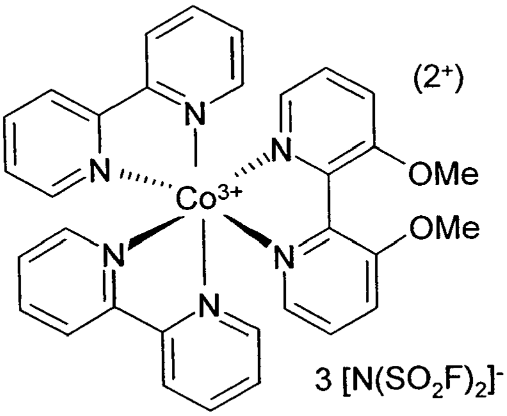

$3\ [N(SO_2F)_2]^-$ ,

$(3^+)$

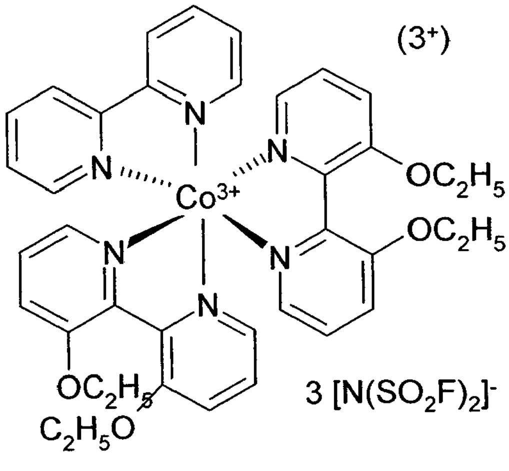

$3\ [N(SO_2F)_2]^-$ ,

$(4^+)$

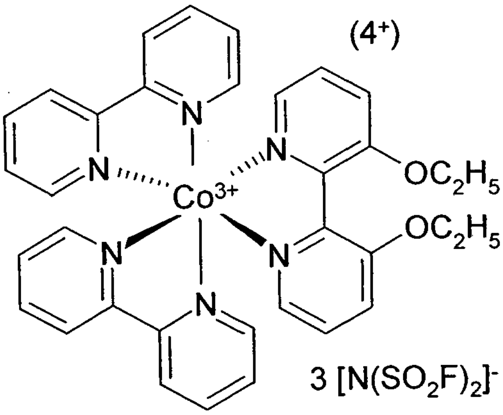

$3\ [N(SO_2F)_2]^-$ ,

$(5^+)$

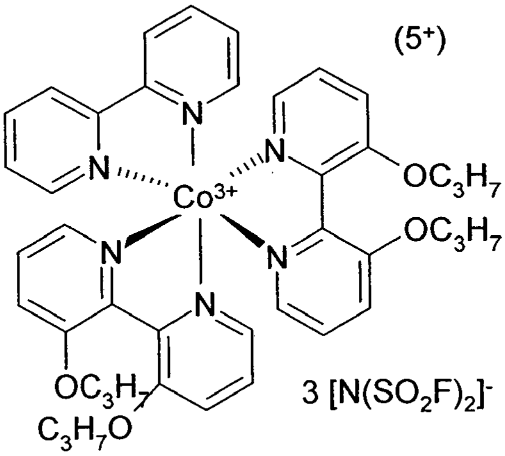

$3\ [N(SO_2F)_2]^-$ ,

$(6^+)$

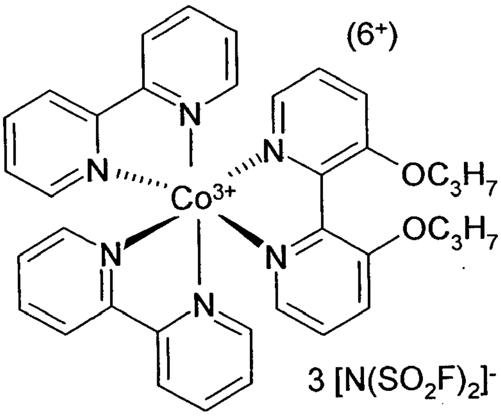

$3\ [N(SO_2F)_2]^-$ ,

$(7^+)$

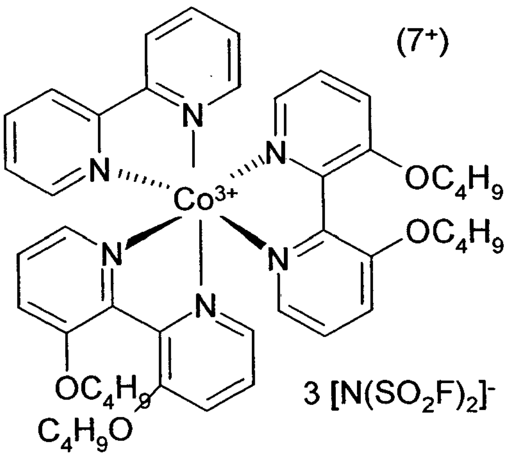

$3\ [N(SO_2F)_2]^-$ ,

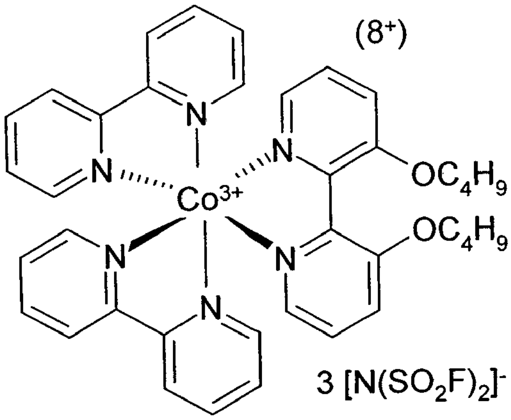

(8$^+$)

3 $[N(SO_2F)_2]^-$ ,

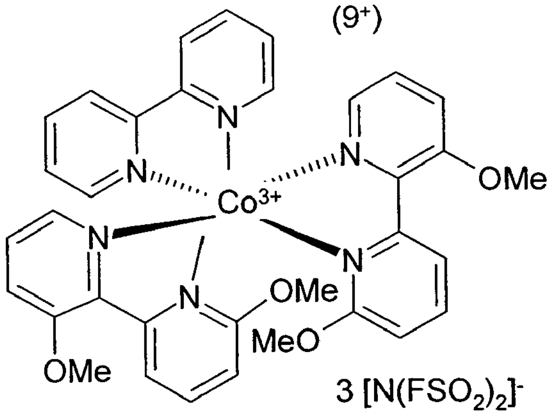

(9$^+$)

3 $[N(FSO_2)_2]^-$ ,

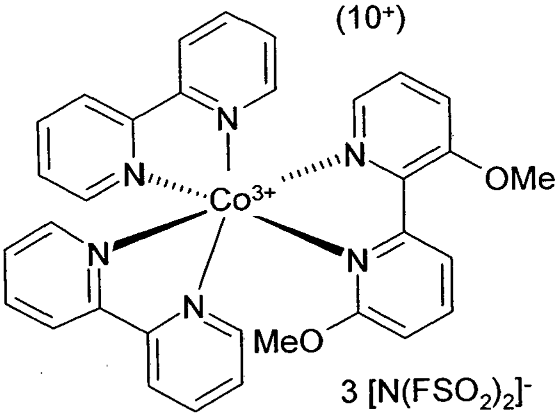

(10$^+$)

3 $[N(FSO_2)_2]^-$ .

OMe means methoxy.

The present invention furthermore relates to a process for the preparation of a compound of formula (I) as described before or preferably described before, comprising the reaction of a compound of formula (II)

Kt $[N(FSO_2)_2]$ (II),

in which
Kt is an alkali metal cation
with Cobalt dichloride or a hydrate thereof
and with one equivalent of bipyridine and two equivalents of a bipyridine of formula (III)

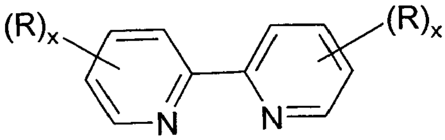

(III)

in which
x is 1 and
R is a straight-chain or branched alkoxy group with 1 to 4 C atoms,
or with two equivalents of bipyridine and one equivalent of a bipyridine of formula (III)
in which
x is 1 and
R is a straight-chain or branched alkoxy group with 1 to 4 C atoms.

The corresponding compounds of formula (I$^+$), (I-1$^+$), (I-2$^+$), (1$^+$) to (10$^+$) are formed within the DSSC or can be synthesized according to the above mentioned process in the presence of an oxidant.

The oxidant or oxidizer may be selected from chlorine gas, bromine, aqueous NaOCl or $H_2O_2$. It is preferred

to use chlorine gas or NaOCl.

Compounds of formula (II) are preferably lithium, potassium or sodium salts. Compounds of formula (II) are commercially available, e.g. $KN(FSO_2)_2$ (from Kanto Chemical Co., Inc., or Mitsubishi Materials Electronic Chemicals Co., Ltd.) or $LiN(FSO_2)_2$ [171611-11-3] (Nippon Shokubai Co., Ltd. Other compounds of formula (II) may be easily prepared through a salt exchange reaction.

Kt in formula (II) is preferably Li or K, particularly preferably K.

Cobalt dichloride or hydrates thereof and bipyridines of formula (III)

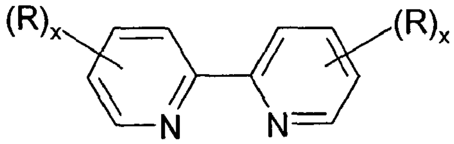

(III)

,

in which

x is 1 and R is defined as described before or preferably described,

are commercially available or can be synthesized according to already known methods in the art as described in "Organikum", 2001, WILEY-VCH, Weinheim; R.C. Larock, "Comprehensive Organic Transformations, A Guide to Functional Group Preparations", Second Edition, 1999, WILEY-VCH, N.Y. Chichester, Weinheim.

The synthesis of compounds of formula (I) is preferably carried out in water or a mixture of water and an organic solvent, preferably water and methanol, and the preferred reaction temperature is room temperature.

The compounds of formula (I), (I-1), (I-2), (1) to (10) and/or the $Co^{II}/Co^{III}$-redox couples corresponding to the compounds of formula (I), (I-1), (I-2), (1) to (10) as explained before according to this invention, are preferably used in electrochemical and/or optoelectronic devices, especially comprised in a charge transport layer.

In one preferred embodiment of the invention, the compounds of formula (I), (I-1), (I-2), or (1) to (10) are comprised in an electrolyte formulation comprised in a charge transport layer.

The present invention therefore relates furthermore to an electrolyte formulation comprising a compound of formula (I) as described above or preferably described herein.

Preferably, the electrolyte formulation according to the invention comprises furthermore the corresponding compound of formula ($I^+$) or nitrosyl compounds, preferably $NOBF_4$, $NOClO_4$, $NOSO_4H$, $(NO)_2XeF_8$ or $NOSnCl_6$, thus forming a redox shuttle.

In an alternative embodiment of the invention, an electrolyte formulation comprises unsubstituted [Co(bipyridyl)$_3$][$N(FSO_2)_2$] and a substituted Cobaltcomplex salt, wherein the salt is substituted one time by R as defined before or preferably defined before in a molar ratio of 1:2 or 2:1.

The invention therefore relates furthermore to an electrolyte formulation comprising the cobaltcomplex salt [Co(bipyridyl)$_3$][($N(FSO_2)_2$)]$_2$ and the cobaltcomplex salt of formula (IV)

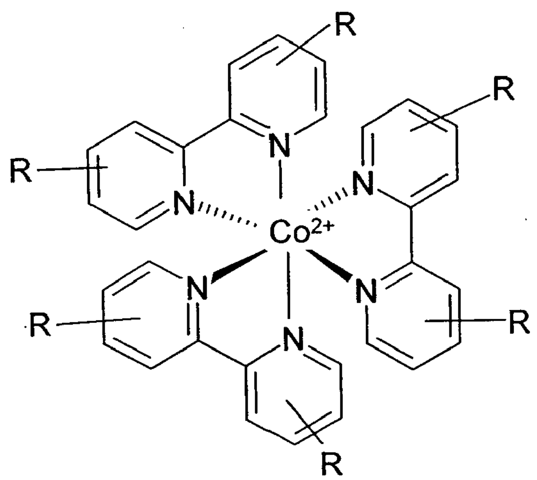

$2\,[N(FSO_2)_2]^-$ (IV)

,

in which

R is a straight-chain or branched alkoxy group with 1 to 4 C atoms,

in a molar ratio of 1:2 or 2:1.

In one preferred embodiment of the invention, the position of the substituents "R" is in position 3 and 3' of the bipyridyl ligand thus forming compounds of formula (IV-1)

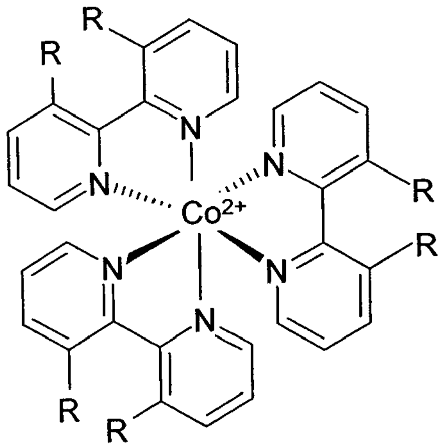

2 $[N(FSO_2)_2]^-$ (IV-1)

,

in which R is defined as described before or preferably described for the compounds of formula (I), (I-1) and (I-2).

In one preferred embodiment of the invention, the position of the substituents "R" is in position 3 and 6' of the bipyridyl ligand thus forming compounds of formula (IV-2)

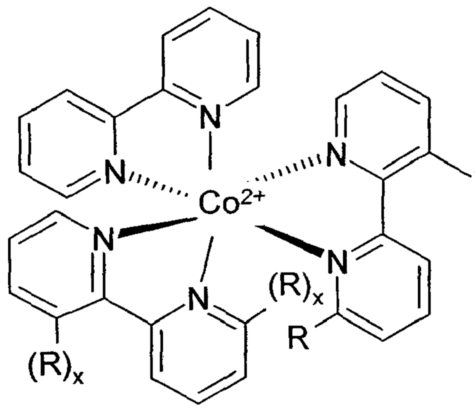

2 $[N(FSO_2)_2]^-$ (IV-2)

,

in which R is defined as described before or preferably described for the compounds of formula (I), (I-1) and (I-2).

The surprising effects with regard to solubility enhancement and thermal stability are also observed in using the mixture of the Cobaltcomplex salts as explained before, or alternatively in using the compounds of formula (I), (I-1) and (I-2) desbribed before.

Both embodiments are alternatives to each other.

It is also preferred for the alternative embodiment of the electrolyte formulation according to the invention that the electrolyte formulation comprises furthermore the salts $[Co(bipyridyl)_3][(N(FSO_2)_2)]_3$ and the cobaltcomplex salt of formula ($IV^+$)

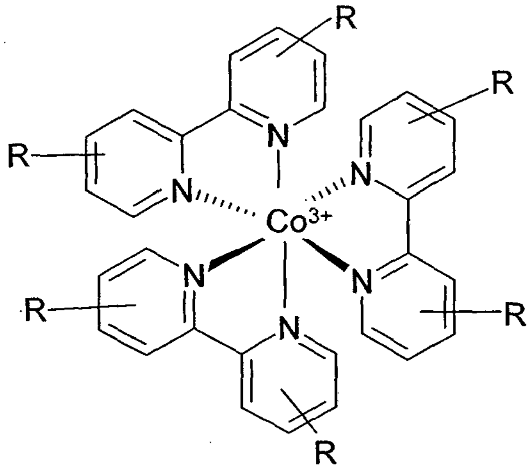

3 $[N(FSO_2)_2]^-$ (IV+)

,

in which
R is a straight-chain or branched alkoxy group with 1 to 4 C atoms,
in a molar ratio of 1:2 or 2:1;
or a nitrosyl compound, preferably $NOBF_4$, $NOClO_4$, $NOSO_4H$, $(NO)_2XeF_8$ or $NOSnCl_6$.

Electrolyte formulations according to the invention as described before can be used in electrochemical and/or optoelectronic devices such as a photovoltaic cell, a light emitting device, an electrochromic or photo-electrochromic device, an electrochemical sensor and/or a biosensor.

Electrolyte formulations according to the invention can be preferably used in photovoltaic cells, preferably in dye sensitized solar cells.

Such electrolyte formulations form a crucial part of the disclosed devices and the performance of the device largely depends on the physical and chemical properties of the various components of the electrolyte formulations.

Electrolyte formulations according to the invention are alternatives to already known electrolyte formulations. They show in the field of electrolyte formulations of dye sensitized solar cells a better thermal stability with improved or equivalent solar-to-electric power-conversion efficiency (PCE, $\eta$) of DSSC in comparison to the already known Cobaltcomplex salts of the prior art.

In chemistry, an electrolyte is any substance containing free ions that make the substance electrically conductive. The most typical electrolyte is an ionic solution, but molten electrolytes and solid electrolytes are also possible.

An electrolyte formulation according to the invention is therefore an electrically conductive medium, basically due to the presence of at least one substance that is present in a dissolved and or in molten state and undergo dissociation into ionic species, i.e. supporting an electric conductivity via motion of ionic species. However, the said electric conductivity may not be of the major relevance to the role of the electrolyte of a dye-sensitised solar cell. Therefore, the scope of this invention is not limited to highly conductive electrolyte media.

The term electrolyte may be used for the term electrolyte formulation as well comprising all ingredients as disclosed for the electrolyte formulation.

The electrolyte formulation may include or comprise, essentially consist of or consist of the said requisite or optional constituents. All compounds or components which can be used in the preparations are either known and commercially available or can be synthesised by known or already described processes.

Typical molar concentrations of the total of the Cobaltcomplex salts according to the invention in the inventive electrolyte formulations range from 0.01 M to 0.8 M, preferably from 0.05 M to 0.6 M.

In general, it is preferred that the molar concentration of the total of the Cobaltcomplex salts comprising Co in oxidation state 2 range from 0.01 to 0.5 M, preferably 0.03 to 0.3 M.

In the preferred embodiment of the electrolyte formulations according to the invention as described before comprising Cobaltcomplex salts containing Co in oxidation state 3, the total of such Cobaltcomplex salts range from 0.01 to 0.5 M, preferably 0.02 to 0.3 M.

In another particular preferred embodiment of the electrolyte formulations according to the invention comprising a compound of formula (I), (I-1), (I-2) or (1) to (10) or comprising a mixture of $[Co(bipyridyl)_3][(N(FSO_2)_2)]_2$ and the cobaltcomplex salt of formula (IV) in the specified molar ratio, the compound $NOBF_4$ is present, preferably in the molar concentration of 0.01 to 0.05 M, preferably 0.04 M.

For the purpose of the present invention, the molar concentration refer to the concentration at 25°C.

The present electrolyte formulation may furthermore comprise a further redox active species such as iodide/tri-iodide, Ferrocene derivatives or Co(II)/Co(III) complex salts such as $Co(II)/Co(III)(dbbip)_2$ in which dbbip means 2,6-bis(1'-butylbenzimidazol-2'-yl)pyridine, the counter anion being either perchlorate, fluoroperfluoroalkylphosphate such as perfluoroethylpentafluorophosphate, or (fluoro)cyanoborate, particularly tetracyanoborate.

Other components of the electrolyte formulation are one or several further salts, e.g. ionic liquids, solvents, and other additives, as indicated further below.

The electrolyte formulation of the present invention comprises an organic solvent and/or comprises one or more ionic liquids.

Organic solvents may be selected from those disclosed in the literature. Preferably, the solvent, if present, has a boiling point higher than 160 degrees centigrade, more preferably higher than 190 degrees such as propylene carbonate, ethylene carbonate, butylene carbonate, gamma-butyrolactone, gamma-valerolactone, glutaronitrile, adiponitrile, N-methyloxazolidinone, N-methylpyrrolidinone, N,N'-dimethylimidazolidinone, N,N-dimethylacetamide, cyclic ureas preferably 1,3-dimethyl-2-imidazolidinone or 1,3-dimethyl-3,4,5,6-tetrahydro-2(1H)-pyrimidinone, glymes preferably tetraglyme, sulfolane, sulfones such as (propane-2-sulfonyl)-benzene, 2-ethanesulfonyl-butane, 2-(2-methoxyethanesulfonyl)-propane, 2-(propane-2-sulfonyl)-butane, 3-methylsulfolane, dimethylsulfoxide, trimethylphosphate and methoxy-substituted nitriles. Other useful solvents are acetonitrile, benzonitrile and or valeronitrile.

In a preferred embodiment of the invention, the electrolyte formulation comprises an organic solvent. In a particular preferred embodiment of the invention, the electrolyte formulation comprises 3-methoxypropionitrile, tetraethylene glycol dimethyl ether or gamma-butyrolactone.

If a solvent is present in the electrolyte formulation, there may further be comprised a polymer as gelling agent, wherein the polymer is polyvinylidenefluoride, polyvinylidene-hexafluropropylene, polyvinylidene-hexafluoropropylene-chlorotrifluoroethylene copolymers, nafion, polyethylene oxide, polymethylmethacrylate, polyacrylonitrile, polypropylene, polystyrene, polybutadiene, polyethyleneglycol, polyvinylpyrrolidone, polyaniline, polypyrrole, polythiophene. The purpose of adding these polymers to electrolyte formulations is to make liquid electrolytes into quasi-solid or solid electrolytes, thus improving solvent retention, especially during aging.

In one embodiment of the invention, the electrolyte formulation according to the invention comprises merely an organic solvent and further additives such as lithium salts, guanidinium thiocyanates or classical additives such as a compound containing a nitrogen atom having non-shared electron pairs, e.g. N-alkylbenzimidazoles or alkyl-pyridines and bases having pKa between 3 to 6.

Lithium salts may be selected from the group lithium tetrafluoroborate, lithium perchlorate, lithium thiocyanate, lithium tetracyanoborate, lithium trifluoromethanesulfonate, lithium hexafluorophosphate, lithium tris(perfluororalkyl)trifluorophosphates, lithium bis(perfluoroalkyl)tetrafluorophosphates, lithium mono(perfluoroalkyl)pentafluorophosphates or lithium perfluoroalkylfluoroborate, wherein the perfluoroalkyl groups each independently are straight-chain or branched perfluoroalkyl groups having 1 to 10 C atoms, preferably 2 to 4 C atoms.

In another embodiment of the invention, the electrolyte formulation according to the invention comprises an organic solvent in less than 50%, and further comprising an ionic liquid as solvent. Preferably, the electrolyte formulation comprises less than 40%, more preferably less than 30%, still more preferably less than 20% and even less than 10 % organic solvent. Most preferably, the electrolyte formulation comprises less than 5% of an organic solvent. For example, it is substantially free of an organic solvent. Percentages are indicated on the basis of weight %.

Ionic liquids or liquid salts are ionic species which consist of an organic cation and a generally inorganic anion. They do not contain any neutral molecules and usually have melting points below 373 K.

Preferred ionic liquids have organic cations comprising a quaternary nitrogen and an anion selected from a $Br^-$, $Cl^-$, a polyhalide ion, a fluoroalkanesulfonate, a fluoroalkanecarboxylate, a tris(fluoroalkylsulfonyl)methide, a bis(fluoroalkylsulfonyl)imide, bis(fluorsulfonyl)imide, a nitrate, a hexafluorophosphate, a tris-, bis- and mono-(fluoroalkyl)fluorophosphate, a tetrafluoroborate, a dicyanamide, a tricyanomethide, a tetracyanoborate, a monohydridotricyanoborate, a dihydridodicyanoborate, a monofluorotricyanoborate, a difluorodicyanoborate, a perfluoroalkylfluoroborate, perfluoroalkylfluorocyanoborate, a thiocyanate, an alkylsulfonate or an alkylsulfate, with fluoroalkane-chain having 1 to 20 C atoms, preferably perfluorinated, fluoroalkyl having 1 to 20 C atoms and alkyl having 1 to 20 C atoms. Fluoroalkane-chain or fluoroalkyl is preferably perfluorinated.

Particularly preferred ionic liquids have cations chosen from the group of 1,1-dialkylpyrrolidinium cations,for example, 1,1-dimethylpyrrolidinium, 1-methyl-1-ethylpyrrolidinium, 1-methyl-1-propylpyrrolidinium, 1-methyl-1-butylpyrrolidinium, 1-methyl-1-pentylpyrrolidinium, 1-methyl-1-hexyl-pyrrolidinium, 1-methyl-1-heptylpyrrolidinium, 1-methyl-1-octylpyrrolidinium, 1-methyl-1-nonylpyrrolidinium, 1-methyl-1-decylpyrrolidinium, 1,1-diethyl-pyrrolidinium, 1-ethyl-1-propylpyrrolidinium, 1-ethyl-1-butylpyrrolidinium, 1-ethyl-1-pentylpyrrolidinium, 1-ethyl-1-hexylpyrrolidinium, 1-ethyl-1-heptyl-pyrrolidinium, 1-ethyl-1-octylpyrrolidinium, 1-ethyl-1-nonylpyrrolidinium, 1-ethyl-1-decylpyrrolidinium, 1,1-dipropylpyrrolidinium, 1-propyl-1-methyl-pyrrolidinium, 1-propyl-1-butylpyrrolidinium, 1-propyl-1-pentylpyrrolidinium, 1-propyl-1-hexylpyrrolidinium, 1-propyl-1-heptylpyrrolidinium, 1-propyl-1-octylpyrrolidinium, 1-propyl-1-nonylpyrrolidinium, 1-propyl-1-decyl-pyrrolidinium, 1,1-dibutylpyrrolidinium, 1-butyl-1-methylpyrrolidinium, 1-butyl-1-pentylpyrrolidinium, 1-butyl-1-hexylpyrrolidinium, 1-butyl-1-heptyl-pyrrolidinium, 1-butyl-1-octylpyrrolidinium, 1-butyl-1-nonylpyrrolidinium, 1-butyl-1-decylpyrrolidinium, 1,1-dipentylpyrrolidinium, 1-pentyl-1-hexyl-pyrrolidinium, 1-pentyl-1-heptylpyrrolidinium, 1-pentyl-1-octylpyrrolidinium, 1-pentyl-1-nonylpyrrolidinium, 1-pentyl-1-decylpyrrolidinium, 1,1-dihexyl-pyrrolidinium, 1-hexyl-1-heptylpyrrolidinium, 1-hexyl-1-octylpyrrolidinium, 1-hexyl-1-nonylpyrrolidinium, 1-hexyl-1-decylpyrrolidinium, 1,1-dihexyl-pyrrolidinium, 1-hexyl-1-heptylpyrrolidinium, 1-hexyl-1-octylpyrrolidinium, 1-hexyl-1-nonylpyrrolidinium, 1-hexyl-1-decylpyrrolidinium, 1,1-diheptyl-pyrrolidinium, 1-heptyl-1-octylpyrrolidinium, 1-heptyl-1-nonylpyrrolidinium, 1-heptyl-1-decylpyrrolidinium, 1,1-dioctylpyrrolidinium, 1-octyl-1-nonyl-pyrrolidinium, 1-octyl-1-decylpyrrolidinium, 1,1-dinonylpyrrolidinium, 1-nonyl-1-decylpyrrolidinium or 1,1-didecylpyrrolidinium. Very particular preference is given to 1-butyl-1-methylpyrrolidinium or 1-propyl-1-methyl-pyrrolidinium, 1-alkyl-1-alkoxyalkylpyrrolidinium cations, for example, 1-methoxymethyl-1-methyl-pyrrolidinium, 1-methoxymethyl-1-ethyl-pyrrolidinium, 1-(2-methoxyethyl)-1-methylpyrrolidinium, 1-(2-methoxyethyl)-1-ethylpyrrolidinium, 1-(2-methoxyethyl)-1-propyl-pyrrolidinium, 1-(2-methoxyethyl)-1-butylpyrrolidinium, 1-(2-ethoxyethyl)-1-methylpyrrolidinium, 1-ethoxymethyl-1-methylpyrrolidinium, 1-ethoxymethyl-1-ethyl-pyrrolidinium. Very particular preference is given to 1-(2-methoxyethyl)-1-methylpyrrolidinium, 1,3-dialkylimidazolium cations, for example, 1-ethyl-3-methylimidazolium, 1-methyl-3-propylimidazolium, 1,2,3-trimethylimidazolium, 1-ethyl-2,3-dimethylimidazolium, 1-propyl-2,3-dimethylimidazolium, 1-butyl-2,3-dimethylimidazolium, 1-butyl-3-methyl-imidazolium, 1-methyl-3-pentylimidazolium, 1-ethyl-3-propylimidazolium, 1-butyl-3-ethylimidazolium, 1-ethyl-3-pentylimidazolium, 1-butyl-3-propyl-imidazolium, 1,3-dimethylimidazolium, 1,3-diethylimidazolium, 1,3-dipropylimidazolium, 1,3-dibutylimidazolium, 1,3-dipentylimidazolium, 1,3-dihexylimidazolium, 1,3-diheptylimidazolium, 1,3-dioctylimidazolium, 1,3-dinonylimidazolium, 1,3-didecylimidazolium, 1-hexyl-3-methylimidazolium, 1-heptyl-3-methylimidazolium, 1-methyl-3-octylimidazolium, 1-methyl-3-nonylimidazolium, 1-decyl-3-methylimidazolium, 1-ethyl-3-hexyl-imidazolium, 1-ethyl-3-heptylimidazolium, 1-ethyl-3-octylimidazolium, 1-ethyl-3-nonylimidazolium or 1-decyl-3-ethylimidazolium. Particularly preferred cations are 1-ethyl-3-methylimidazolium, 1-butyl-3-methylimidazolium or 1-methyl-3-propylimidazolium, 1-alkoxyalkyl-3-alkylimidazolium cations, for example 1-methoxymethyl-3-methylimidazolium, 1-methoxymethyl-3-ethylimidazolium, 1-methoxymethyl-3-butylimidazolium, 1-(2-methoxyethyl)-3-methylimidazolium, 1-(2-methoxyethyl)-3-ethylimidazolium, 1-(2-methoxyethyl)-3-propylimidazolium, 1-(2-methoxyethyl)-3-butylimidazolium, 1-(2-ethoxyethyl)-3-methylimidazolium, 1-ethoxymethyl-3-methylimidazolium and 1-alkenyl-3-alkylimidazolium cations, for example 1-allyl-3-methyl-imidazolium or 1-allyl-2,3-dimethylimidazolium and the anions are selected as described before.

Preferably, the ionic liquids are selected from salts comprising cations as described above and anions such as bis(fluorosulfonyl)imide, thiocyanate, tetracyanoborate, monohydridotricyanoborate, monofluorotricyanoborate, perfluoroalkylborate, perfluoroalkylfluorocyanoborate, hexafluorophosphate or perchlorate.

Particularly preferred ionic liquids have additionally the anion monohydridotricyanoborate or monofluorotricyanoborate. The solubility of compounds of formula (I), (I-1), (I-2), (1) to (10) is enhanced in such preferred ionic liquids, preferably in an ionic liquid consisting of cations as disclosed before and anions selected from monohydridotricyanoborate or monofluorotricyanoborate.

The electrolyte formulation of the invention may further comprise metal oxide nanoparticles like $SiO_2$, $TiO_2$, $Al_2O_3$, MgO or ZnO, for example, which are also capable of increasing solidity and thus solvent retention.

In another embodiment, the electrolyte formulation of the present invention further comprises at least one compound containing a nitrogen atom having non-shared electron pairs. Examples of such compounds are found in EP 0 986 079 A2, starting on page 2, lines 40-55, and again from page 3, lines 14 extending to page 7, line 54, which are expressly incorporated herein by reference. Preferred examples of compounds having non-shared electron pairs include imidazole and its derivatives, particularly benzimidazole and its derivatives.

The electrolyte formulation of the invention has many applications. For example, it may be used in an optoelectronic and/or electrochemical device such as a photovoltaic cell, a light emitting device, an electrochromic or photoelectrochromic device, an electrochemical sensor and/or a biosensor.

The present invention therefore relates furthermore to an electrochemical and/or optoelectronic device comprising a first and a second electrode and, between said first and second electrode, a charge transport layer comprising a compound of formula (I), (I-1), (I-2), (1) to (10) as described before, or an electrolyte formulation as described before.

Preferably, the device according to the invention is a photoelectric conversion device, preferably a photovoltaic cell, particularly preferably a dye-sensitized solar cell, a solid state dye-sensitized solar cell or a perovskite containing solar cell, very particularly preferably a dye-sensitized solar cell.

Preferably, the charge transport layer of the device according to the invention comprises an organic solvent and/or comprises one or more ionic liquids. Particularly preferably, the charge transport layer of the device according to the invention comprises an organic solvent.

Organic solvents and ionic liquids are described in detail before.

In another embodiment of the invention, the compounds of formula (I), (I-1), (I-2) or (1) to (10) are comprised in the charge transport layer of an electrochemical or optoelectronic device as a p-dopant. Preferred devices for this application are perovskite containing solar cells or solid state dye-sensitized solar cells comprising hole transport materials.

There are no restrictions per se with respect to the choice of the perovskite material.

Suitable pervoskite materials are $CsSnI_3$, $CH_3NH_3PbI_2Cl$, $CH_3NH_3PbI_3$, $CH_3NH_3Pb(I_{1-x}Br_x)_3$, $CH_3NH_3SnI_2Cl$,

$CH_3NH_3SnI_3$ or $CH_3NH_3Sn(I_{1-x}Br_x)_3$ wherein x is each independently defined as follows: $(0<x\leq1)$.

The charge transport layer according to the invention as described before may furthermore comprise an insulator such as alumina as described in Michael M. Lee et al, Science, 338, 643, 2012.

There are no restrictions per se with respect to the choice of the first and second electrode or the hole transport material of a solid state dye-sensitized solar cell. The substrate may be rigid or flexible.

A suitable solid state dye-sensitized solar cell is a solid state dye-sensitized solar cell comprising a glass substrate coated with F-doped $SnO_2$, a dense layer of $TiO_2$, the inventive charge-transport layer as described or preferably described before and a counter electrode.

Preferably, the counter electrode is a gold electrode, a silver electrode or a platinum electrode. Particularly preferably, the counter electrode is a gold or silver electrode.

Suitable hole transport materials are well-known in the art. Preferred hole transport materials for combination are spiro-OMeTAD, 2,2',7,7'-tetrakis-(N,N'-di-4-methoxy-3,5-dimethylphenylamine)-9,9'-spirofluorene, tris(p-anisyl)amine, N,N,N',N'-tetrakis(4-methoxyphenyl)-1,1'-biphenyl-4,4'diamine, 2,7-bis[N,N-bis(4-methoxy-phenyl)amino]-9,9-spirobifluorene, poly(3-hexylthiophene) (P3HT), poly(3,4-ethylenedioxythiophene)-poly(styrenesulfonate) (PEDOT:PSS), poly[bis(4-phenyl)(2,4,6-trimethylphenyl)amine] (PTAA), NiO and $V_2O_5$.

Additionally, the invention relates to a method of preparing an electrochemical device and/or optoelectronic device as described or preferably described before, the method comprising the steps of:

- providing a first and a second electrode;
- providing a charge transport layer,
- adding to said charge transport layer a compound of formula (I), (I-1), (I-2), (1) to (10) as described before or preferably described before or
- adding to said charge transport layer an electrolyte formulation as described before or preferably described before.

Dye sensitized solar cells are disclosed in US 6,861,722, for example. In dye -sensitized solar cells including solid state dye-sensitized solar cells, a dye is used to absorb the sunlight to convert into the electrical energy. There are no restrictions per se with respect to the choice of the sensitizing dye as long as the LUMO energy state is marginally above the conduction bandedge of the photoelectrode to be sensitized. Examples of dyes are disclosed in Nanoenergy, de Souza, Flavio Leandro, Leite, Edson Roberto (Eds.), Springer, ISBN 978-3-642-31736-1, pages 58 to 74, black dyes as described in US 8,383,553 or dyes as disclosed in EP 0 986 079 A2, EP 1 180 774 A2 or EP 1 507 307 A1.

Preferred dyes are organic dyes such as MK-1, MK-2 or MK-3 (its structures are described in figure 1 of N. Koumura et al, J.Am.Chem.Soc. Vol 128, no.44, 2006, 14256-14257), D29 as described on page 4 of WO 2012/001033, D35 as described on page 4 of WO 2012/001033, D102 (CAS no. 652145-28-3), D-149 (CAS no. 786643-20-7), D205 (CAS no. 936336-21-9), D358 (CAS no. 1207638-53-6), YD-2 as described in T. Bessho et al, Angew. Chem. Int. Ed. Vol 49, 37, 6646-6649, 2010, Y123 (CAS no. 1312465-92-1), bipyridin-Ruthenium dyes such as N3 (CAS no. 141460-19-7), N719 (CAS no. 207347-46-4), Z907 (CAS no. 502693-09-6), C101 (CAS no. 1048964-93-7), C106 (CAS no. 1152310-69-4), K19 (CAS no. 847665-45-6), HRS-1 (CAS no. 906061-30-1 as disclosed in K.J. Jiang et al, Chem. Comm. 2460, 2006) or terpyridine-Ruthenium dyes such as N749 (CAS no. 359415-47-7).

The structure of D205 is

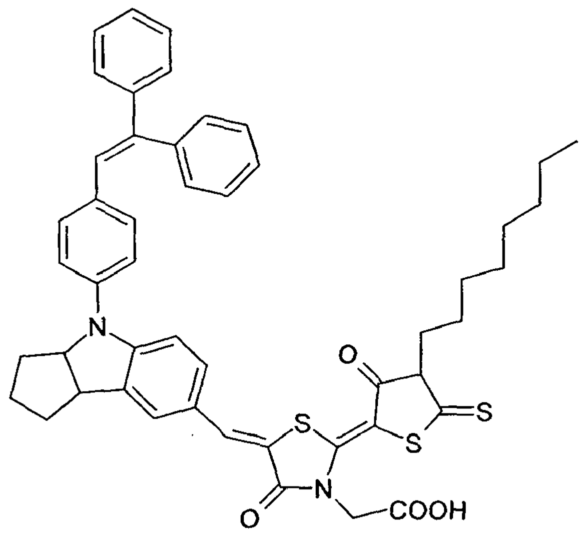

The structure of D358 is

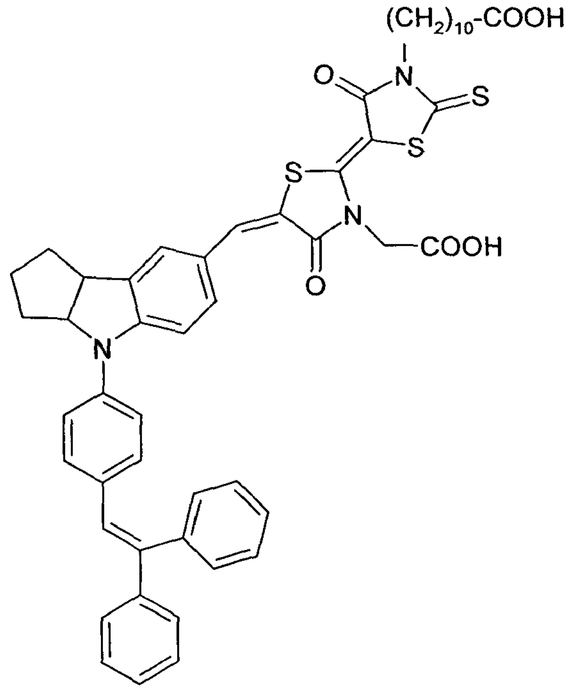

.

Particularly preferred dyes are Z907 or Z907Na which are both an amphiphilic ruthenium sensitizer, D29, D35, Y123, C106, D358 or HRS-1. The dye Z907Na means NaRu(2,2'-bipyridine-4-carboxylic acid-4'-carboxylate)(4,4'-dinonyl-2,2'-bipyridine)$(NCS)_2$.

A very particularly preferred dye is D358. It is preferred to use a dye-formulation in an organic solvent for the preparation of a DSSC. Such dye-formulations preferably contain chenodeoxycholic acid (CDCA).

For example, a dye-sensitized solar cell comprises a photo-electrode, a counter electrode and, between the photo-electrode and the counter electrode, an electrolyte formulation or a charge transporting material, and wherein a sensitizing dye is absorbed on the surface of the photo-electrode, on the side facing the counter electrode.

According to a preferred embodiment of the device according to the invention, it comprises a semiconductor, the electrolyte formulation as described above and a counter electrode.

According to a preferred embodiment of the invention, the semiconductor is based on material selected from the group of Si, $TiO_2$, $SnO_2$, $Fe_2O_3$, $WO_3$, ZnO, $Nb_2O_5$, CdS, ZnS, PbS, $Bi_2S_3$, CdSe, GaP, InP, GaAs, CdTe, $CuInS_2$, and/or $CuInSe_2$. Preferably, the semiconductor comprises a mesoporous surface, thus increasing the surface optionally covered by a dye and being in contact with the electrolyte. Preferably, the semiconductor is present on a glass support or plastic or metal foil. Preferably, the support is conductive.

The device of the present invention preferably comprises a counter electrode. For example, fluorine doped tin oxide or tin doped indium oxide on glass (FTO- or ITO-glass, respectively) coated with Pt, carbon of preferably conductive allotropes, polyaniline or poly (3,4-ehtylenedioxythiophene) (PEDOT). Metal substrates such as stainless steel or titanium sheet may be possible substrates beside glass.

The device of the present invention in which the charge transport layer is a solvent and/or ionic liquid based electrolyte formulation may be manufactured as the corresponding device of the prior art by simply replacing the electrolyte by the electrolyte formulation of the present invention. For example, in the case of dye-sensitized solar cells, device assembly is disclosed in numerous patent literature, for example WO 91/16719 (examples 34 and 35), but also scientific literature, for example in Barbé, C.J., Arendse, F., Comte, P., Jirousek, M., Lenzmann, F., Shklover, V., Grätzel, M. J. Am. Ceram. Soc. 1997, 80, 3157; and Wang, P., Zakeeruddin, S. M., Comte, P., Charvet, R., Humphry-Baker, R., Grätzel, M. J. Phys. Chem. B 2003, 107, 14336.

Preferably, the sensitized semi-conducting material serves as a photoanode. Preferably, the counter electrode is a cathode.

The present invention also provides a method for preparing a photoelectric cell comprising the step of bringing the electrolyte formulation of the invention in contact with a surface of a semiconductor, said surface optionally being coated with a sensitizer. Preferably, the semiconductor is selected from the materials given above, and the sensitizer is preferably selected from a dye as disclosed above.

Preferably, the electrolyte formulation may simply be poured on the semiconductor. Preferably, it is applied to the otherwise completed device already comprising a counter electrode by creating a vacuum in the internal lumen of the cell through a hole in the counter electrode and adding the electrolyte formulation as disclosed in the reference of Wang et al., J. Phys. Chem. B 2003, 107, 14336.

The present invention will now be illustrated, without limiting its scope, by way of the following examples. Even without further comments, it is assumed that a person skilled in the art will be able to utilise the above description in the broadest scope. The preferred embodiments and examples should therefore merely be regarded as descriptive disclosure which is absolutely not limiting in any way.

Examples:

The substances are characterised by means of GC-MS and NMR spectroscopy. The NMR-spectra are measured in deuterated solvent $CDCl_3$ and $CD_3OD$ by use of JEOL JNM-ECA 300 with Deuterium Lock. The resonance frequency for different nuclear are: $^1H$: 399.78 $MH_z$ and $^{13}C$: 99.95 MHz. The following references are used: TMS for $^1H$ und $^{13}C$ spectra. For cobalt(II) complex analysis, small amount of $NOBF_4$ was added to prepared sample solution just before analysis to oxidize cobalt metal's valence ($2^+ \rightarrow 3^+$) to clarify spectra. The GC-MS-spectra are measured by use of Agilent 7890A-5975C system with Agilent J&W 19091S-433: 30m*250 μm*0.25 μm capirally column. Melting point measurement are carried out by use of Mettler-Toledo FP81 MBC Cell and FP90 Central Processor.

Examples:

Example 1:Synthesis of 3,3'-dimethoxy-2,2'-bipyridine (a ligand for complexes 1, $1^+$, 2, $2^+$, and 11)

To a stirred solution of nickel(II) chloride hexahydrate (Merck, 10.8g, 0.045 mol) and triphenylphosphine (Merck, 46.8g, 0.18 mol) in dimethylformamide (Merck, 226 mL) under nitrogen at 50 °C (internal temperature), zinc powder (Kanto Chemical, 3.2g, 0.045 mol) is added and kept stirring for 1 hour at the same temperature. 2-Bromo-3-methoxypyridine (Tokyo Chemical industry, 8.4g, 0.045 mol) is added to the red-brown suspension. After 4 hours the mixture is diluted by 200 mL of chloroform (Merck) and is poured into ammonia solution (Merck), then washed. After evaporation of solvents, the residue is re-solved in 50 mL of chloroform then 10 mL of 10% HCl solution (Merck) are added into chloroform solution (the formed HCl salt is transferred to the water phase). After washing twice with 25 mL of chloroform a time and separation, 38% NaOH solution is added until the water phase is basic, and re-extracted three times with 25 mL of chloroform a time. Then the organic phase is dried over $MgSO_4$. 3,3'-Dimethoxy-2,2'-bipyridine is obtained as colorless solid (5.38g, 55% yield) in >99.9% purity by recrystallization (from EtOH / $Et_2O$) without column chromatography.
Melting point (°C): 136.0 (lit. 136)
$^1H$-NMR (δ ppm, $CDCl_3$) 3.75 (s, 6H), 7.27 (d, J = 5.0 Hz, 2H), 7.29 (d, J = 5.0 Hz, 2H), 8.32 (dd, J = 5.0, 9.6 Hz, 2H).
$^{13}C$-NMR (δ ppm, $CDCl_3$) 56.3, 56.3, 120.6, 120.6, 120.7, 120.7, 141.0, 141.0, 153.8, 154.0, 154.0
MS (EI): 216 ($M^+$).

Example 2: Synthesis of 3,6'-dimethoxy-2,2'-bipyridine (a ligand for complexes 9, $9^+$, 10, $10^+$, and 12)

To a stirred solution of 3-methoxypyridine (Tokyo Chemical Industry, 1.05 mL, 10 mmol) in 50 mL of THF (dried, Sigma-Aldrich) n-BuLi is added (1.5M in n-hexane, Tokyo Chemical Industry, 13 mL, 19.47 mmol) through a septum at -70 °C under nitrogen. The reaction mixture is kept at this temperature for 1 hour. An anhydrous solution of $ZnCl_2$ (1.0M in $Et_2O$, Tokyo Chemical Industry, 25 mL, 25 mmol) is added at -70 °C. The reaction mixture is then warmed to room temperature. After the addition of $Pd(PPh_3)_4$ (Tokyo Chemical Industry, 376 mg, 3.158 mmol) and 2-bromo-3-methoxypyridine (Tokyo Chemical Industry, 2.4 mL, 19.47 mmol), the mixture is refluxtd for 12 hours, cooled, and poured into a solution of EDTA. After the general treatment, the crude product is purified by column chromatography (silica gel). Eluent: chloroform/EtOH (50 : 1), 472 mg (22% yield).
Melting point (°C): 138.0
MS (EI): 216 ($M^+$)
$^1H$-NMR (δ ppm, $CDCl_3$) 3.75 (s, 3H), 3.75 (s, 3H), 6.42 (d, J = 5.2 Hz, 1H), 7.27 (dd, J = 5.2, 9.5 Hz, 1H), 7.29 (d, J = 5.2 Hz, 1H), 7.50 (d, J = 5.2 Hz, 1 H), 7.66 (dd, J = 5.2, 9.5 Hz, 1H), 8.35 (d, J = 5.2Hz, 1 H).
$^{13}C$-NMR (δ ppm, $CDCl_3$) 55.9, 56.2, 107.5, 111.8, 121.8, 124.1, 139.3, 140.8, 152.1, 153.3, 153.8, 163.7.

Example 3: Synthesis of $[Co(bipy)_3][N(FSO_2)_2]_2$

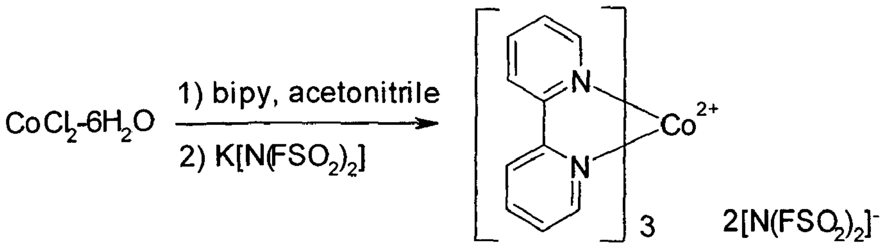


508 mg (2.143 mmol) $CoCl_2 \cdot 6H_2O$ dissolved in 2 mL of acetonitrile and 1 g (6.403 mmol) bipy in 7 mL of acetonitrile are mixed together at 50 °C. The reaction mixture becomes immediately red-brown. After 10 min the solution of 1 g (4.695 mmol) $K[N(FSO_2)_2]$ in 5 mL of water is added to the reaction mixture and heated under reflux. The salt precipitates immediately and is filtered off. The filtrate is evaporated. Crystals are recrystallized from residue (from EtOH), then washed with 5 mL of water and two times with 10 mL of $Et_2O$. The product $[Co(bipy)_3][N(FSO_2)_2]_2$ is dried in vacuum at room temperature. The yield is 1.885 g (99%).
$^1$H-NMR (δ ppm, $CD_3OD$) 7.87 (dd, J = 5.5, 6.4 Hz, 2H), 8.40 (t, J = 7.7 Hz, 2H), 8.53 (d, J = 7.7 Hz, 2H), 8.82 (d, J = 7.7Hz, 2H).

Example 4: Synthesis of [Co(3,3'-dimethoxy-2,2'-bipy)$_2$bipy][N(FSO$_2$)$_2$]$_2$ (Compound 1)

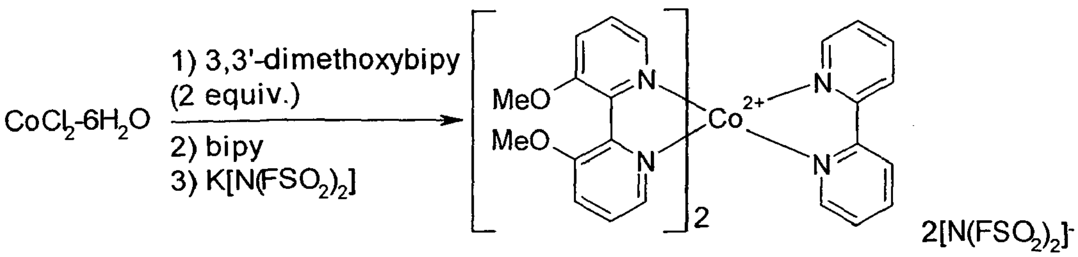


138 mg (0.578 mmol) $CoCl_2 \cdot 6H_2O$ dissolved in 110 mL of acetonitrile and 250 mg (6.403 mmol) 3,3'-dimethoxy-2,2'-bipy in 5 mL of acetonitrile are mixed together at 50 °C. After 30 min. 90.3 mg (0.578 mmol) bipy in 5 mL of acetonitrile are added at 50 °C. Then the solution of 279 mg (1.272 mmol) $K[N(FSO_2)_2]$ in 1 mL of water is added to the reaction mixture and heated under reflux. The salt precipitates immediatelyand is filtered off, and the filtrate is evaporated. Crystals are recrystallized from residue (from EtOH / $Et_2O$), then washed with 5 mL of water and two times with 10 mL of $Et_2O$. The product [Co(3,3'-dimethoxy-2,2'-bipy)$_2$bipy][N(FSO$_2$)$_2$]$_2$ is dried in vacuum at room temperature. The yield is 150.1 mg (26%).

$^1$H-NMR (δ ppm, $CD_3OD$) 4.09 (s, 3,3'-dimethoxybipy-6H), 7.89 (t, J = 7.8 Hz, bipy-2H), 8.22 (m, 3,3'-dimethoxybipy-2H), 8.43 (t, J = 7.8 Hz, bipy-2H), 8.52 (d, J = 9.2 Hz, 3,3'-dimethoxybipy-2H), 8.55 (d, J = 8.2Hz, bipy-2H), 8.60 (d, J = 9.2 Hz, 3,3'-dimethoxybipy-2H), 8.84 (d, J = 5.5 Hz, bipy-2H).

Example 5: Synthesis of [Co(3,3'-dimethoxy-2,2'-bipy)bipy$_2$][N(FSO$_2$)$_2$]$_2$ (Compound 2)

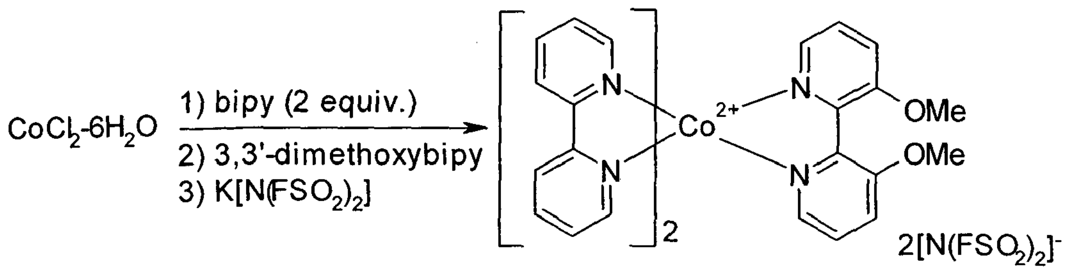


152 mg (0.640 mmol) $CoCl_2 \cdot 6H_2O$ dissolved in 120 mL of acetonitrile and 200 mg (6.403 mmol) bipy in 5 mL

of acetonitrile are mixed together at 50 °C. After 30 min. 138 mg (0.640 mmol) 3,3'-dimethoxybipy in 6 mL of acetonitrile are added at 50 °C. Then the solution of 309 mg (1.272 mmol) $K[N(FSO_2)_2]$ in 1.5 mL of water is added to the reaction mixture and heated under reflux. The salt precipitates immediately and is filtered off, and the filtrate is evaporated. Crystals are recrystallized from residue (from EtOH / $Et_2O$), then washed with 5 mL of water and two times with 10 mL of $Et_2O$. The product $[Co(3,3'\text{-dimethoxy-}2,2'\text{-bipy})bipy_2][N(FSO_2)_2]_2$ is dried in vacuum at room temperature. The yield is 148.8 mg (25%).

$^1$H-NMR (δ ppm, $CD_3OD$) 4.07 (s, 3,3'-dimethoxybipy-3H), 7.89 (dd, J = 5.5, 6.4 Hz, bipy-4H), 8.20 (dd, J = 5.5, 9.2 Hz, 3,3'-dimethoxybipy-2H), 8.42 (dt, J = 1.4, 7.8 Hz, bipy-2H), 8.52 (d, J = 9.2 Hz, 3,3'-dimethoxybipy-2H), 8.54 (d, J = 7.8 Hz, bipy-2H), 8.59 (d, J = 9.2 Hz, 3,3'-dimethoxybipy-2H), 8.84 (d, J = 5.5 Hz, bipy-2H).

Example 6: Synthesis of $[Co(3,3'\text{-dimethoxy-}2,2'\text{-bipy})_3][N(FSO_2)_2]_2$ (Compound 11)

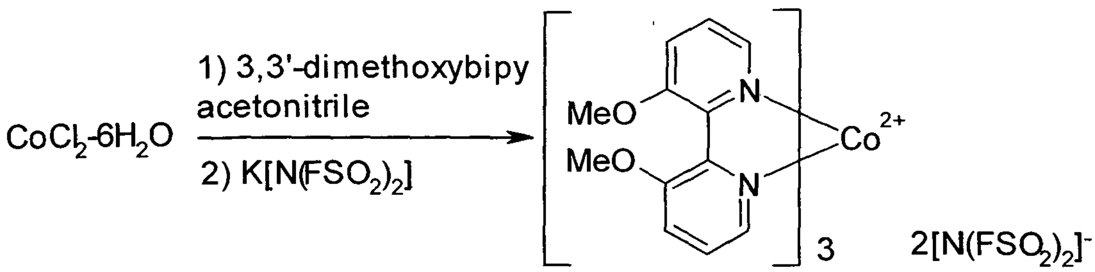


183 mg (0.771 mmol) $CoCl_2 \cdot 6H_2O$ dissolved in 1 mL of acetonitrile and 500 mg (2.312 mmol) 3,3'-dimethoxy-2,2'-bipy in 2 mL of acetonitrile are mixed together at 50 °C. The reaction mixture becomes immediately red-brown. In 10 min the solution of 372 mg (1.696 mmol) $K[N(FSO_2)_2]$ in 2 mL of water is added to the reaction mixture and heated under reflux. The salt precipitates immediatelyand is filtered off, and the filtrate is evaporated.

Crystals are recrystallized from residue (from acetone / EtOH), then washed with 5 mL of water and two times with 10 mL of $Et_2O$. The product $[Co(3,3'\text{-dimethoxy-}2,2'\text{-bipy})_3][N(FSO_2)_2]_2$ is dried in vacuum at room temperature. The yield is 723.4 mg (88%).

$^1$H-NMR (δ ppm, $CD_3OD$) 4.07 (s, 6H), 8.20 (dd, J = 5.5, 9.6 Hz, 2H), 8.52 (d, J = 9.2 Hz, 2H), 8.58 (d, J = 9.2 Hz, 2H).

Example 7: Synthesis of $[Co(3,6'\text{-dimethoxy-}2,2'\text{-bipy})_2bipy][N(FSO_2)_2]_2$ (Compound 9)

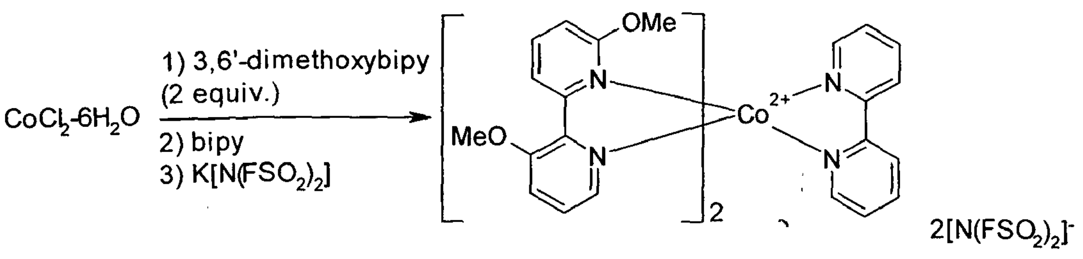


138 mg (0.578 mmol) $CoCl_2 \cdot 6H_2O$ dissolved in 110 mL of acetonitrile and 250 mg (6.403 mmol) 3,6'-dimethoxy-2,2'-bipy in 5 mL of acetonitrile are mixed together at 50 °C. After 30 min. 90.3 mg (0.578 mmol) bipy in 5 mL of acetonitrile are added at 50 °C. Then the solution of 279 mg (1.272 mmol) $K[N(FSO_2)_2]$ in 1 mL of water is added to the reaction mixture and heated under reflux. The salt precipitates immediately and is filtered off, and the filtrate is evaporated. Crystals are recrystallized from residue (from EtOH / $Et_2O$), then washed with 5 mL of water and two times with 10 mL of $Et_2O$. The product $[Co(3,6'\text{-dimethoxy-}2,2'\text{-bipy})_2bipy][N(FSO_2)_2]_2$ is dried in vacuum at room temperature. The yield is 150.1 mg (26%).

$^1$H-NMR (δ ppm, $CD_3OD$) 4.05 (s, 3,6'-dimethoxybipy-3H), 4.07 (s, 3,6'-dimethoxybipy-3H), 7.35 (d, J = 5.2 Hz, 3,6'-dimethoxybipy-1H), 7.57 (dd, J = 5.2, 9.5 Hz, 3,6'-dimethoxybipy-1H), 7.89 (t, J = 7.8 Hz, bipy-2H), 8.43 (t, J = 7.8 Hz, bipy-2H), 8.52 (d, J = 9.2 Hz, 3,6'-dimethoxybipy-1H), 8.55 (d, J = 8.2Hz, bipy-2H), 8.60 (d, J = 9.2 Hz, 3,3'-dimethoxybipy-2H), 8.73 (d, J =

5.2 Hz, 3,6'-dimethoxybipy-1H), 8.84 (d, J = 5.5 Hz, bipy-2H), 8.89 (dd, J = 5.2, 9.5 Hz, 3,6'-dimethoxybipy-1H), 8.92 (d, J = 5.2Hz, 3,6'-dimethoxybipy-1H).

Example 8: Synthesis of [Co(3,6'-dimethoxy-2,2'-bipy)bipy$_2$][-(FSO$_2$)$_2$]$_2$ (Compound 10)

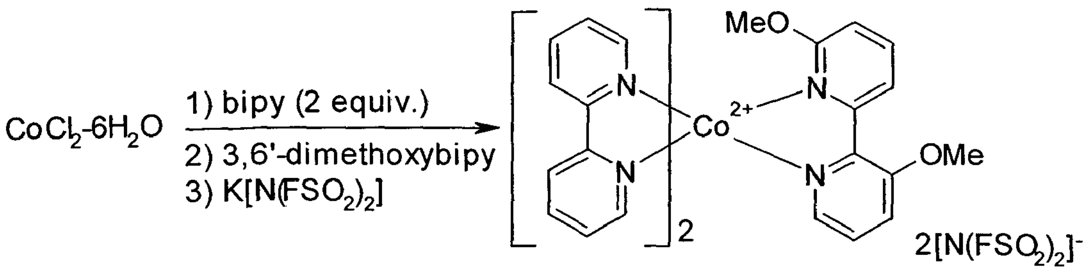


152 mg (0.640 mmol) $CoCl_2 \cdot 6H_2O$ dissolved in 120 mL of acetonitrile and 200 mg (6.403 mmol) bipy in 5 mL of acetonitrile are mixed together at 50 °C. After 30 min. 138 mg (0.640 mmol) 3,3'-dimethoxybipy in 6 mL of acetonitrile are added at 50 °C. Then the solution of 309 mg (1.272 mmol) K[N(FSO$_2$)$_2$] in 1.5 mL of water is added to the reaction mixture and heated under reflux. The salt precipitates immediately and is filtered off, and the filtrate is evaporated. Crystals are recrystallized from residue (from EtOH / $Et_2O$), then washed with 5 mL of water and two times with 10 mL of $Et_2O$. The product [Co(3,6'-dimethoxy-2,2'-bipy)bipy$_2$][$^-$(FSO$_2$)$_2$]$_2$ is dried in vacuum at room temperature. The yield is 148.8 mg (25%).

$^1$H-NMR (δ ppm, $CD_3OD$) 4.05 (s, 3,6'-dimethoxybipy-3H), 4.06 (s, 3,6'-dimethoxybipy-3H), 7.35 (d, J = 5.2 Hz, 3,6'-dimethoxybipy-1H), 7.57 (dd, J = 5.2, 9.5 Hz, 3,6'-dimethoxybipy-1H), 7.89 (dd, J = 5.5, 6.4 Hz, bipy-4H), 8.20 (dd, J = 5.5, 9.2 Hz, 3,3'-dimethoxybipy-2H), 8.42 (dt, J = 1.4, 7.8 Hz, bipy-2H), 8.52 (d, J = 5.2 Hz, 3,6'-dimethoxybipy-1H), 8.54 (d, J = 7.8 Hz, bipy-2H), 8.73 (d, J = 5.2 Hz, 3,6'-dimethoxybipy-1H), 8.84 (d, J = 5.5 Hz, bipy-2H) 8.89 (dd, J = 5.2, 9.5 Hz, 3,6'-dimethoxybipy-1H), 8.92 (d, J = 5.2Hz, 3,6'-dimethoxybipy-1H).

Example 9: Synthesis of [Co(3,6'-dimethoxy-2,2'-bipy)$_3$][N(FSO$_2$)$_2$]$_2$ (Compound 12)

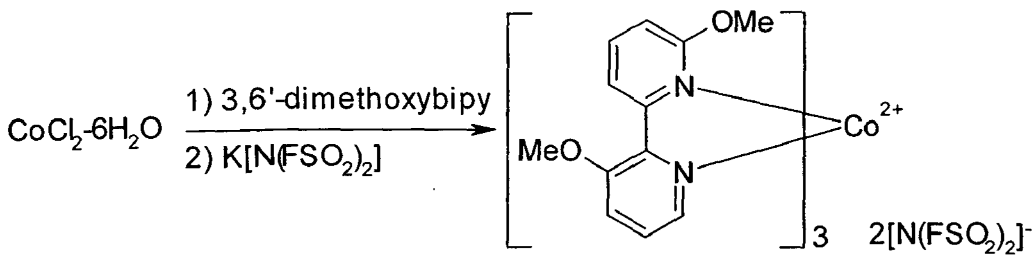


183 mg (0.771 mmol) $CoCl_2 \cdot 6H_2O$ dissolved in 1 mL of acetonitrile and 500 mg (2.312 mmol) 3,3'-dimethoxy-2,2'-bipy in 2 mL of acetonitrile are mixed together at 50 °C. The reaction mixture becomes immediately red-brown. In 10 min the solution of 372 mg (1.696 mmol) K[N(FSO$_2$)$_2$] in 2 mL of water is added to the reaction mixture and heated under reflux. The salt precipitates immediately and is filtered off, and the filtrate is evaporated. Crystals are recrystallized from residue (from acetone / EtOH), then washed with 5 mL of water and two times with 10 mL of $Et_2O$. The product [Co(3,6'-dimethoxy-2,2'-bipy)$_3$][N(FSO$_2$)$_2$]$_2$ is dried in vacuum at room temperature. The yield is 723.4 mg (88%).

$^1$H-NMR (δ ppm, $CDCl_3$) 4.06 (s, 3H), 4.07 (s, 3H), 7.35 (d, J = 5.2 Hz, 1H), 7.57 (dd, J = 5.2, 9.5 Hz, 1H), 8.52 (d, J = 5.2 Hz, 1H), 8.73 (d, J = 5.2 Hz, 1 H), 8.89 (dd, J = 5.2, 9.5 Hz, 1 H), 8.92 (d, J = 5.2Hz, 1 H).

Example A:

A layer of mesoporous $TiO_2$ as an electrode is prepared based on the disclosure of Wang P. et al., J. Phys. Chem. B 2003, 107, 14336, in particular page 14337. To prepare a transparent nanoporous $TiO_2$ electrode, a screen printing paste containing terpineol solvent and nanoparticulate $TiO_2$ of anatase phase with 30 nm diameter is deposited

on a transparent conductive substrate to 5 mm x 5 mm squared shape by using a screen printer. The paste is dried for 10 minutes at 120 degrees Celsius. The layer is then sintered at 500 degrees Celsius for an hour with the result of an transparent layer of 2 microns thick. After sintering, the electrode is immersed in 40 mM aqueous solution of $TiCl_4$ (Merck) for 30 minutes at 70 degrees Celsius and then rinsed quickly with pure water sufficiently. Thus $TiCl_4$-treated electrode is dried at 500 degrees Celsius for 30 minutes just before dye sensitization. The electrode is dipped into a 0.5 mM D358 dye solution of acetonitrile (Merck HPLC grade) and tert-butyl alcohol (Merck), v:v = 1:1 for 2 hours at 23 degrees Celsius, optionally comprising CDCA in a concentration of 1 mM. The counter electrode is prepared with thermal pyrolysis method as disclosed in the reference above. A droplet of 5 mM solution of platinic acid (Merck) is casted at 8 $\mu l/cm^2$ and dried on a conductive substrate. The dye sensitized solar cell is assembled by using 30 micron thick Bynel (DuPont, USA) hot-melt film to seal up by heating. The internal space is filled with each of the electrolyte formulations as described below in detail to produce the corresponding devices.

The dye D358 is an indoline dye.

The used electrolyte formulations generally consists of an organic solvent, 0.5M compound of formula (I) as specified in the following tables, 0.04 M $NOBF_4$, 21 mM $LiBF_4$ and 150 mM N-butylbenzimidazole.

In order to obtain accurate light intensity level, Air Mass 1.5 Global (AM1.5G) simulated sunlight is calibrated spectrally according to Seigo Ito et al. "Calibration of solar simulator for evaluation of dye-sensitized solar cells" Solar Energy Materials & Solar Cells 82 (2004) 421. The measurements of photocurrent-voltage curves are carried out for devices placed on a black plate chilled down to 25°C under 1 Sun illumination. A photomask of 4 mm x 4 mm is placed on top of the fabricated devices to define the light projection area. Energy conversion efficiency is generally the ratio between the useful output of an energy conversion machine and the input of light radiation, in energy terms, determined by using adjustable resistant load to optimize the electric power output.

Thermal stability test:

The DSSCs were stored at 85°C in the dark in ambient atmosphere.

The measurements to identify the PCE after storage are carried out as described before.

The retention rate is calculated as the ratio of the PCE after storage to the the initial PCE.

$$\text{retention rate} = \frac{\text{PCE after storage}}{\text{initial PCE}}$$

Table 1 summarizes the results of the thermal stability test of an electrolyte formulation with the solvent 3-methoxypropionitrile; the dye solution of D358 contained 1 mM CDCA as marked:

| Cobaltcomplex salt used | Initial PCE [%] | PCE [%] after 85°C for 18 hours | Retention Rate | Solubility |
|---|---|---|---|---|
| without CDCA | | | | |
| *$[Co(bipy)_3][N(FSO_2)_2]_2$ | 1.92* | 0.88* | 0.46* | good |
| Compound (2) | 3.40 | 0.18 | 0.05 | good |
| Compound (1)* | 1.81 | 1.25 | 0.69 | very good |
| *Compound (12) | 3.09* | 0.26* | 0.08* | good |
| with CDCA | | | | |
| *$[Co(bipy)_3][N(FSO_2)_2]_2$ | 2.53* | 0.84* | 0.33* | good |
| Compound (2) | 3.21 | 0.09 | 0.03 | good |
| Compound (1)* | 2.50 | 1.63 | 0.65 | very good |
| *Compound (11) | 3.34* | 0.20* | 0.06* | good |
| * not according to the invention | | | | |

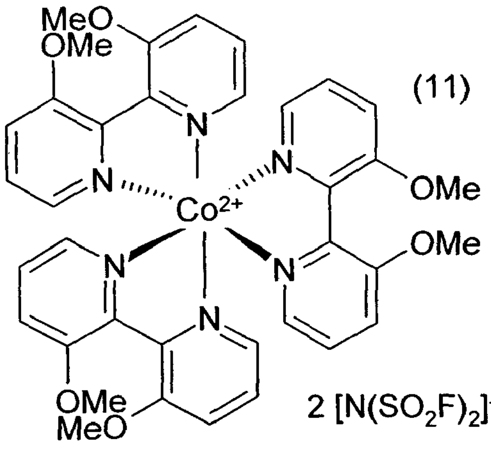

(11)

2 $[N(SO_2F)_2]^-$ : OMe means methoxy.

PCE = power conversion efficiency

Table 2 summarizes the results of the thermal stability test of an electrolyte formulation with the solvent tetraethylene glycol dimethyl ether; the dye solution of D358 contained 1 mM CDCA:

| Cobaltcomplex salt used | Initial PCE [%] | PCE [%] after 85°C for 24 hours | Retention Rate | Solubility |
|---|---|---|---|---|
| *$[Co(bipy)_3][N(FSO_2)_2]_2$ | 0.30* | 0.03* | 0.1* | good |
| Compound (2) | 0.67 | 0.06 | 0.09 | good |
| Compound (1)* | 1.20 | 0.51 | 0.43 | good |
| *Compound (11) | 0.79* | 0.02* | 0.03* | good |
| * not according to the invention | | | | |

Table 3 summarizes the results of the thermal stability test of an electrolyte formulation with the solvent gamma-butyrolactone; the dye solution of D358 contained 1mM CDCA:

| Cobaltcomplex salt used | Initial PCE [%] | PCE [%] after 85°C for 24 hours | Retention Rate | Solubility |
|---|---|---|---|---|
| *$[Co(bipy)_3][N(FSO_2)_2]_2$ | 2.47* | 0.71* | 0.29* | good |
| Compound (2) | 1.26 | 0.57 | 0.45 | good |
| Compound (1) | 2.30 | 1.40 | 0.61 | good |
| *Compound (11) | 3.23* | 1.79* | 0.55* | good |
| * not according to the invention | | | | |

Table 4 summarizes the results of the thermal stability test of an electrolyte formulation with the solvent 3-methoxypropionitrile; the dye solution of D358 contained 1 mM CDCA:

| Cobaltcomplex salt used | Initial PCE [%] | PCE [%] after 85°C for 61 hours | Retention Rate | Solubility |
|---|---|---|---|---|
| *$[Co(bipy)_3][N(FSO_2)_2]_2$ | 2.19* | 1.06* | 0.48* | bad |
| Compound (10) | 2.02 | 1.29 | 0.64 | very good |

(continued)

| Cobaltcomplex salt used | Initial PCE [%] | PCE [%] after 85°C for 61 hours | Retention Rate | Solubility |
|---|---|---|---|---|
| Compound (9) | 1.17 | 0.97 | 0.83 | bad |
| *Compound (12) | 0.02* | 0.01* | 0.56* | bad |
| * not according to the invention | | | | |

Compound (12); OMe means methoxy:

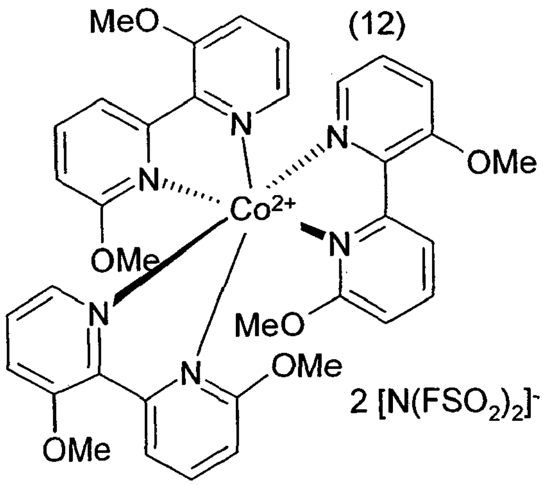

(12)

$2\ [N(FSO_2)_2]^-$

.

## Claims

1. Compounds of formula (I)

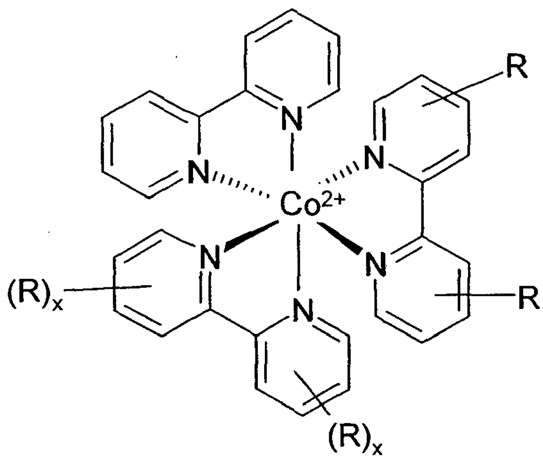

$2\ [N(FSO_2)_2]^-$ (I)

,

in which
x is 0 or 1 and
R is a straight-chain or branched alkoxy group with 1 to 4 C atoms.

2. Compounds according to claim 1 in which the substituents R are in position 3 and 3' of the bipyridyl ligand or in position 3 and 6' of the bipyridyl ligand.

3. Compounds according to claim 1 or 2 in which the substituents are methoxy.

4. Process for the preparation of a compound of formula (I) according to one or more of claims 1 to 3 comprising the reaction of a compound of formula (II)

$$Kt\,[N(FSO_2)_2] \qquad (II),$$

in which
Kt is an alkali metal cation
with Cobalt dichloride or a hydrate thereof
and with one equivalent of bipyridine and two equivalents of a bipyridine of formula (III)

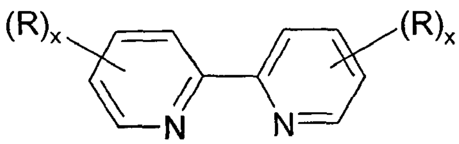

(III)

in which
x is 1 and
R is a straight-chain or branched alkoxy group with 1 to 4 C atoms, or with two equivalents of bipyridine and one equivalent of a bipyridine of formula (III)
in which
x is 1 and
R is a straight-chain or branched alkoxy group with 1 to 4 C atoms.

5. An electroyte formulation comprising a compound of formula (I) according to one or more of claims 1 to 3.

6. An electrolyte formulation comprising the cobaltcomplex salt $[Co(bipyridyl)_3][(N(FSO_2)_2)]_2$ and the cobaltcomplex salt of formula (IV)

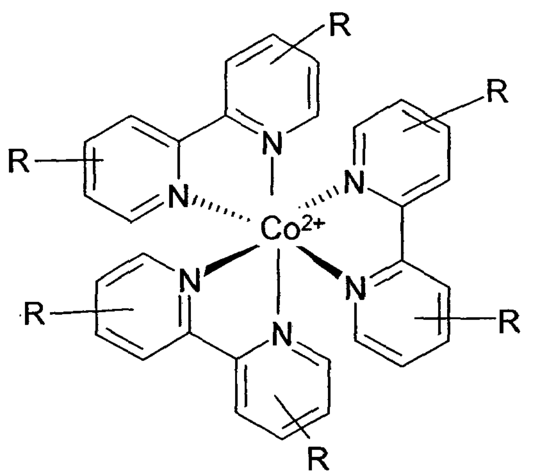

$2\,[N(FSO_2)_2]^-$ (IV)

,

in which
R is a straight-chain or branched alkoxy group with 1 to 4 C atoms, in a molar ratio of 1:2 or 2:1.

7. The electrolyte formulation according to claim 5 or 6 comprising the Cobaltcomplex salts in total in concentrations from 0.01 M to 0.8 M, preferably from 0.05 M to 0.6 M.

8. An electrochemical and/or optoelectronic device comprising a first and a second electrode and, between said first and second electrode, a charge transport layer comprising a compound of formula (I) according to one or more of claims 1 to 3 or an electrolyte formulation according to claim 5 or 6.

**9.** The device according to claim 8 which is a photoelectric conversion device.

**10.** The device according to claim 8 or 9 which is a dye-sensitized solar cell, a solid-state dye-sensitized solar cell or a perovskite containing solar cell.

**11.** The device according to claim 8, 9 or 10, wherein said charge transport layer comprises an organic solvent and/or comprises one or more ionic liquids.

**12.** Use of compounds of formula (I) according to one or more of claims 1 to 3 as p-type dopants in a device according to claims 8, 9 or 10.

**13.** A method of preparing an electrochemical device according to one or more of claims 8 to 10, the method comprising the steps of:

- providing a first and a second electrode;
- providing a charge transport layer,
- adding to said charge transport layer a compound of formula (I) according to one or more of claims 1 to 3 or adding the electrolyte formulation according to claim 6.

**14.** A method to enhance the solubility of Cobaltcomplex salts with bis(fluorosulfonyl)imide, hexafluorophosphate or perchlorate anions having bipyridyl ligands comprising the step of substituting the 3 and 3' position or the 3 and 6' position of the bipyridyl ligand with an alkoxy group having 1 to 4 C atoms.

Europäisches Patentamt
European Patent Office
Office européen des brevets

# EUROPEAN SEARCH REPORT

Application Number
EP 14 00 3875

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE WPI Week 201270 Thomson Scientific, London, GB; AN 2012-L68245 XP002738058, & WO 2012/118346 A2 (DONG JIN SEMICHEM CO LTD) 7 September 2012 (2012-09-07) * abstract * -& WO 2012/118346 A2 (DONGJIN SEMICHEM CO LTD [KR]; AN HYUN-CHEOL [KR]; YOON JUNG-HYUN [KR];) 7 September 2012 (2012-09-07) * the whole document * ----- | 1-14 | INV. C07F15/06 H01L51/00 H01L31/0224 |
| Y | NOLAN JESSE P ET AL: "Tuning the electrochemistry of homoleptic cobalt 4,4'-disubstituted-2,2'-bipyridine redox m", ELECTROCHIMICA ACTA, vol. 108, 13 July 2013 (2013-07-13), pages 690-697, XP028757676, ISSN: 0013-4686, DOI: 10.1016/J.ELECTACTA.2013.07.016 * Co(bpy-OMe)3(PF6)2 * ----- | 1-14 | |
| Y | TECK MING KOH ET AL: "Influence of 4-tert -Butylpyridine in DSCs with Co II/III Redox Mediator", JOURNAL OF PHYSICAL CHEMISTRY C, vol. 117, no. 30, 1 August 2013 (2013-08-01), pages 15515-15522, XP055180853, ISSN: 1932-7447, DOI: 10.1021/jp403918q * Co(bpy)3(TFSI)2 * ----- | 1-14 | TECHNICAL FIELDS SEARCHED (IPC) C07F H01L |
| A,D | WO 2012/001033 A1 (DYENAMO AB [SE]; GIBSON ELIZABETH [GB]; FELDT SANDRA [SE]; GABRIELSSON) 5 January 2012 (2012-01-05) * abstract * ----- | 1-14 | |

1 The present search report has been drawn up for all claims

| Place of search | Date of completion of the search | Examiner |
|---|---|---|
| The Hague | 1 April 2015 | Duval, Eric |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 00 3875

This annex lists the patent family members relating to the patent documents cited in the above-mentioned European search report.
The members are as contained in the European Patent Office EDP file on
The European Patent Office is in no way liable for these particulars which are merely given for the purpose of information.

01-04-2015

| Patent document cited in search report | Publication date | Patent family member(s) | Publication date |
|---|---|---|---|
| WO 2012118346 A2 | 07-09-2012 | NONE | |
| WO 2012118346 A2 | 07-09-2012 | NONE | |
| WO 2012001033 A1 | 05-01-2012 | CN 103003903 A | 27-03-2013 |
| | | EP 2589056 A1 | 08-05-2013 |
| | | JP 2013535086 A | 09-09-2013 |
| | | US 2013160855 A1 | 27-06-2013 |
| | | WO 2012001033 A1 | 05-01-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2012001033 A
- EP 0986079 A2
- US 6861722 B
- US 8383553 B
- EP 1180774 A2
- EP 1507307 A1
- WO 9116719 A


### Non-patent literature cited in the description


- **H. NUSBAUMER et al.** *J. Phys. Chem. B,* 2001, vol. 105, 10461-10464
- **J.-H. YUM ; E. BARANOFF ; F. KESSLER ; T. MOEHL ; S. AHMAD ; T. BESSHO ; A. MARCHIORO ; E. GHADIRI ; J.-E. MOSER ; C. YI.** *Nature Communications,* 2012, vol. 3, 631
- **H.N. TSAO ; C. YI ; T. MOEHL ; J.-H. YUM ; S.M. ZAKEERUDDIN ; M.K. NAZEERUDDIN ; M. GRÄTZEL.** *ChemSusChem,* 2011, vol. 4, 591-594
- *J. Am. Chem. Soc.,* 2010, vol. 132, 16714-16724
- Organikum. WILEY-VCH, 2001
- **R.C. LAROCK.** Comprehensive Organic Transformations, A Guide to Functional Group Preparations. WILEY-VCH, 1999
- **MICHAEL M. LEE et al.** *Science,* 2012, vol. 338, 643
- Nanoenergy. Springer, 58-74
- **N. KOUMURA et al.** *J.Am.Chem.Soc.,* 2006, vol. 128 (44), 14256-14257
- **T. BESSHO et al.** *Angew. Chem.,* 2010, vol. 49 (37), 6646-6649
- **K.J. JIANG et al.** *Chem. Comm.,* 2006, 2460
- **BARBÉ, C.J. ; ARENDSE, F. ; COMTE, P. ; JIROUSEK, M. ; LENZMANN, F. ; SHKLOVER, V. ; GRÄTZEL, M.** *J. Am. Ceram. Soc.,* 1997, vol. 80, 3157
- **WANG, P. ; ZAKEERUDDIN, S. M. ; COMTE, P. ; CHARVET, R. ; HUMPHRY-BAKER, R. ; GRÄTZEL, M.** *J. Phys. Chem. B,* 2003, vol. 107, 14336
- **WANG et al.** *J. Phys. Chem. B,* 2003, vol. 107, 14336
- **WANG P. et al.** *J. Phys. Chem. B,* 2003, vol. 107, 14336
- **SEIGO ITO et al.** Calibration of solar simulator for evaluation of dye-sensitized solar cells. *Solar Energy Materials & Solar Cells,* 2004, vol. 82, 421